# EUROPÄISCHE PATENTSCHRIFT

(11) **EP 3 407 400 B1**
(45) Veröffentlichungstag und Bekanntmachung des Hinweises auf die Patenterteilung: **05.07.2023**
(21) Anmeldenummer: 17172618.5
(22) Anmeldetag: 24.05.2017
(51) Int. Cl.: H10K 50/856, H10K 50/858, F21S 43/145

(54) **VERFAHREN ZUR BEHANDLUNG VON OBERFLÄCHEN VON ALS LICHTQUELLEN IN FAHRZEUGLEUCHTEN VORGESEHENEN OLEDS UND LEUCHTMITTEL MIT MINDESTENS EINER ENTSPRECHEND BEHANDELTEN OLED ALS LICHTQUELLE**
METHOD FOR TREATING THE SURFACES OF OLEDS INTENDED FOR USE AS LIGHT SOURCES IN VEHICLE LIGHTS AND LIGHT SOURCE WITH AT LEAST ONE CORRESPONDINGLY TREATED OLED AS LIGHT SOURCE
PROCÉDÉ DE TRAITEMENT DE SURFACES DE DELO DISPOSÉES DANS DES PHARES DE VÉHICULES EN TANT QUE SOURCES LUMINEUSES ET ÉCLAIRAGES AYANT AU MOINS UNE DELO AINSI TRAITÉE EN TANT QUE SOURCE LUMINEUSE

(43) Veröffentlichungstag der Anmeldung: 28.11.2018
(73) Patentinhaber: odelo GmbH, 70329 Stuttgart (DE)
(72) Erfinder: SCHWEGLER, Veit, 70372 Stuttgart (DE); VOLLMER, Marco, 71332 Waiblingen (DE); EBENBICHLER, Albert, 73728 Esslingen (DE)
(74) Vertreter: Benninger, Johannes

(56) Entgegenhaltungen:
- DE-A1- 10 353 992
- DE-A1-102005 002 837
- DE-A1-102015 215 139
- DE-T5-112014 002 456
- US-A1- 2008 197 764
- US-A1- 2017 133 348

## Beschreibung

Die Erfindung betrifft ein Verfahren zur Behandlung von Oberflächen von als Lichtquellen in Fahrzeugleuchten vorgesehenen OLEDs zum Zwecke einer Steigerung der Verwendbarkeit von verfügbaren OLEDs als Lichtquellen in Fahrzeugleuchten gemäß dem Oberbegriff des Anspruchs 1 und ein Leuchtmittel mit mindestens einer OLED mit wenigstens einer entsprechend behandelten Oberfläche als Lichtquelle gemäß dem Oberbegriff des Anspruchs 6.

Insbesondere beschäftigt sich die Erfindung mit einer Verbesserung der Verfügbarkeit von OLEDs für Fahrzeuganwendungen durch eine Veredelung von Oberflächen von OLEDs zum Zwecke der Verwendbarmachung unter Anderem auch solcher OLEDs für Fahrzeuganwendungen, die für diesen Zweck nicht einsetzbar sind und bislang im Anschluss an deren Herstellung aussortiert werden müssen.

Als Lichtquellen kommen in Fahrzeugleuchten Glühlampen, Gasentladungslampen sowie unter anderem wegen ihres wesentlichen Vorzugs einer wesentlich höheren Lichtausbeute bei gleicher Leistungsaufnahme vermehrt anorganische Leuchtdioden (LED) zum Einsatz.

Die Verwendung kurz als OLED (Organic Light Emitting Diode; OLED) bezeichneter organischer Leuchtdioden als Lichtquellen verspricht nicht nur die selben Vorzüge wie bei der Verwendung von LEDs, sondern darüber hinausgehende Kostenvorteile.

OLEDs sind durch eine Beaufschlagung mit Strom zum leuchten anregbare Dünnschichtbauelemente. Eine OLED besteht aus wenigstens einem Stapel umfassend organisch halbleitende Materialien mit mindestens einer zwischen elektrisch leitenden, beispielsweise metallischen Schichten für Anode und Kathode eingeschlossen Emitterschicht.

Die auch als Schichtstapelhöhe bezeichnete Stärke oder anders ausgedrückt Dicke der Schichten liegt in einer Größenordnung von etwa 100 nm. Typischerweise beträgt sie je nach Aufbau 100 nm bis 500 nm.

Zum Schutz gegen Wasser, Sauerstoff sowie zum Schutz gegen andere Umwelteinflüsse, wie etwa Kratzbeschädigung und/oder Druckbelastung sind OLEDs typischerweise mit einem anorganischen Material, insbesondere mit Glas verkapselt.

Eine effektive Verkapselung gegenüber Sauerstoff und Wasser zu einem Substrat hin, auf dem die eigentliche OLED einschließlich deren einer oder mehreren Emitterschichten Schicht um Schicht aufgebaut ist, geschieht durch eine Dünnglas-Schicht im oder auf dem Substrat.

Zwar gibt es Anstrengungen, das Glas durch Kunststoff zu ersetzen, die jedoch insbesondere um beispielsweise die Lebensdaueranforderung von Fahrzeugleuchten und deren Lichtquellen mit mehreren 1000 Stunden hinreichend gut zu erfüllen noch nicht vom gewünschten Erfolg gekrönt sind, weil die Dichtigkeit der alternativen Materialien für die Verkapselung nicht ausreichend gut genug ist.

Im Unterschied zu anorganischen Leuchtdioden benötigen OLEDs keine einkristallinen Materialien. Im Vergleich zu LEDs lassen sich OLEDs daher in kostengünstiger Dünnschichttechnik herstellen. OLEDs ermöglichen dadurch die Herstellung flächiger Lichtquellen, die einerseits sehr dünn und andererseits als durch die Lichtscheibe einer Fahrzeugleuchte hindurch sichtbare leuchtende Fläche eingesetzt einen besonders homogenes Erscheinungsbild aufzuweisen versprechen.

Die Verwendung von OLEDs als Lichtquellen im Automotivbereich ist noch relativ neu. Es gibt hierzu bisher nur einen Erfahrungsschatz von wenigen Jahren - insbesondere im Bereich der Außenbeleuchtung, da hier durch schädliche Umweltbedingungen bedingt erhöhte Anforderungen an die Technologie gesetzt werden. Daher sind auch die Fertigungsprozesse und die -qualität dieser OLEDs noch nicht ganz ausgereift und befinden sich daher insbesondere hinsichtlich Fahrzeuganwendungen in einer teilweise grundlegenden Optimierungs- und Überarbeitungsphase.

Um in Fahrzeugleuchten einsetzbar zu sein, müssen OLEDs den an Fahrzeugkomponenten von und innerhalb Fahrzeugleuchten gestellten und während deren Entwicklung beispielsweise vermittels Shakerprüfung, chemische und mechanische Exposition sowie Klimakammer simulierten und in Form von technischen Anforderungen formulierten Einsatzbedingungen bezüglich thermischen, mechanischen und weiteren, auch kombinierten Umweltbelastungen, wie etwa Schadgas, Feuchtigkeit, Feuchte zusammen mit Wärme, gerecht werden.

Eine große Herausforderung stellt für die OLEDs dabei der Einfluss von durch Wasser, Wasserdampf, Wassermoleküle gebildete Feuchtigkeit dar. Dieser sorgt insbesondere in Kombination mit hohen Temperaturen dazu, dass durch Fehlstellen in der Verkapselung und/oder Versiegelung der OLED an die organischen Schichten unter Anderem Wassermoleküle gelangen können, welche die organischen Schichten irreversibel schädigen und zu einem Ausfall oder Teilausfall der Emitterschicht führen. Dies lässt sich auch in die Lebensdauer für Bauteile in Fahrzeuganwendungen abbildenden Versuchen nachstellen. Bei einem Test eines solchen Versuchs wird die mit einem Leuchtmittel mit mindestens einer OLED als Lichtquelle ausgestattete Fahrzeugleuchte einer 85°C warmen Umgebungstemperatur und einer relativen Luftfeuchte von 85% über mehrere Stunden ausgesetzt. Hierbei zeigen sich bei unzureichender Verkapselung Dark Spots genannte dunkle Flecken oder Punkte in der leuchtenden Fläche die aufgrund der an Verkapselungsfehlstellen hindurchdiffundierenden/hindurch gelangenden Wassermoleküle auftreten. Da diese aufgrund der Verkapselungsfehlstellen auftreten kann dort mit der Zeit immer mehr Wasser hindurchgelangen und dadurch wächst und/oder vergrößert sich der Dark Spot mit der Zeit.

Eine zusätzliche Einschränkung erfahren OLEDs dadurch, dass die Herstellung leuchtender Flächen, welche scharfkantig, d.h. ohne Abrundungen, winklige Strukturen nachbilden durch die im Bereich spitzer Ecken und im Bereich von Innenwinkeln ergebender Stromspitzen im die eigentliche OLED bildenden Substrataufbau scheitert.

Hierdurch kommt es zu lokalen Hot Spots, einhergehend mit so genannten Dark Spots, Dunkelstellen in Folge einer frühzeitigen Alterung bis hin zu einer frühzeitigen Zerstörung der Emitterschicht durch hohe Temperatureinwirkung an diesen Stellen.

In diesem Zusammenhang sei auch ein als Pixelschrumpfung (Pixel Shrinkage) bezeichnetes Phänomen zu nennen, bei dem der durch die Außenkante der Leuchtfläche gebildete Randbereich aufgrund der hohen Stromdichten wegbrennt. Dies hat eine unschöne, ausgefranste Leuchtflächenaußenkontur zur Folge, die im Allgemeinen eine Spezifikationsverletzung darstellt. Auch kann es zu fortschreitender Beschädigung der Schichten von diesem Bereich aus auf benachbarte Bereiche kommen, da durch die hohe Stromdichte auch ein großer Wärmeeintrag in Form von Abwärme aufgrund einer lichttechnischen Effizienz von weniger als 100% in diesem Bereich vorherrscht.

Zusammengefasst sind die besonderen automobilen Einsatzbedingungen für OLEDs durch den Einfluss von hohen Temperaturen, Temperaturschwankungen, Temperaturschocks, Feuchtigkeit, Erschütterungen, ultraviolette Strahlung (UV-Strahlung), Schadgase, wie etwa Abgase von Verbrennungsprozessen, einhergehend mit einer hohen geforderten Lebensdauer von mindestens 8000 h Betriebsdauer sowie eine beispielsweise durch eine spezifizierte Gesamtlebensdauer eines Fahrzeugs von mindestens 15 Jahren definierte Lagerfähigkeit verhältnismäßig hoch im Vergleich zu anderen OLED-Produkten, wie beispielsweise Wohnungs- und Arbeitsplatzleuchtmittel, in Fernsehern verbauten Bildschirmen oder Mobiltelefon-Displays.

Solche robusten und resistenten OLEDs sind derzeit nur mit hohem Aufwand und/oder in einer nicht ausreichenden Stückzahl herstellbar. Letzteres ist aktuell bedingt durch einen hohen Ausschuss, da durch eine als Screening bezeichnete Überwachung in der Fertigung unter Aussortieren von fehlerbehafteten Teilen eine große Anzahl an produzierten OLEDs aussortiert werden muss, da sie nicht die entsprechende Qualität aufweisen. Die Folge ist, dass sich eine Großserie mit vielen 10.000 OLEDs aktuell als unwirtschaftlich erweist, da hierdurch die OLED-Preise zu hoch für den Markt sind.

Weiterhin besteht aktuell eine mangelnde Verfügbarkeit an OLEDs, da einerseits der Ausschuss zu hoch ist und zusätzlich die Maschinenkapazitäten noch nicht ausreichen.

Darüber hinaus können nicht alle OLED-Fehler durch ein Screening erkannt werden und/oder einzelne Fehler werden erst nach der Auslieferung sichtbar, wie beispielsweise das Wachstum von anfangs winzigen Dark Spots und/oder Entstehung von kurzgeschlossenen Bereichen in der OLED.

Zusätzlich zu den bereits oben genannten Fehlern können bei OLEDs im angeschalteten Zustand, dem so genannten Warmzustand oder -design, unter anderem folgende Fehler auftreten:
- Bright Spots (helle Flecken)
- Wolken
- Farb-Luminanzverläufe
- Inhomogenitäten
- Delamination

Im ausgeschalteten Zustand, dem so genannten Kaltzustand oder -design, können bei OLEDs unter anderem folgende Fehler auftreten:
- Kratzer
- Schlieren
- Verunreinigungen, wie etwa Staub.

Aktuell ist ein großer technischer Aufwand nötig, einhergehend mit einem großen Ausschuss, um eine entsprechende Anzahl von für Fahrzeuganwendungen einsetzbare OLEDs in ausreichender Qualität herzustellen. Aufgrund der nötigen aufwändigen Screeningmaßnahmen im Herstellungsprozess und trotz der strengen Reinraummaßnahme, werden viele OLEDs in der Fertigung aussortiert, die den Anforderungen nicht genügen. Dies mindert somit die Ausbringungsmenge.

Darüber hinaus sind kosmetische Fehler, wie Dark Spots, für die optische Anmutung im Warmdesign eine große Herausforderung, da diese nicht nur als einzelne kleine schwarze Punkte in der Leuchtfläche, sondern in einer großen Zahl mit wachsender Größe auftreten können. Wird dies erst in der fertigen Fahrzeugleuchte bemerkt, wird dies als durch eine Mangelbeseitigung zu behebender Qualitätsmangel erachtet, der zu einer hohen Zahl von Reklamationsfällen oder Rückrufaktionen führt.

Die modernen Fertigungsmethoden von Fahrzeugleuchten aus heutzutage überwiegend stoffschlüssig miteinander verbundenen Leuchtengehäusen und Lichtscheiben sehen jedoch keinen nachträglichen Austausch von als OLEDs ausgeführten Lichtquellen vor. Eine Mangelbeseitigung ist daher nur durch einen kompletten Austausch der betroffenen Fahrzeugleuchten möglich, einhergehend mit einem hohen Kostenaufwand und einer hohen Umweltbelastung aufgrund der verschwendeten Ressourcen.

Sowohl zur Verwirklichung von Lichtquellen für Fahrzeuganwendungen mit im Kaltdesign beispielsweise bevorzugt spiegelnden OLEDs, als auch zur Abwendung negativer Qualitätseindrücke aufgrund unterschiedlicher Helligkeiten innerhalb von OLED-Leuchtflächen fehlt eine Lösung, um die Ausbringungsmengen der verfügbaren OLEDs einhergehend mit einem gegenüber einer vergleichbaren OLED-Menge gesteigerten Qualitätseindruck zu erhöhen.

Durch DE 10 2015 215 139 A1 und DE 10 2005 002 837 A1 ist eine Anordnung einer Struktur auf einer OLED bekannt.

US2017133348 A1 beschreibt eine OLED Lichtquelle, z.B. für eine Fahrzeugleuchte, welche Strukturen zur lokalen Minderung der Helligkeit enthält.

Durch US 2008/197764 A1 ist eine vollflächige Auftragung eines die Lichtauskopplung erhöhenden Materials auf ein transparentes Substrat einer Lichtquelle auf Basis einer organischen Elektrolumeneszenz-Schicht bekannt.

Eine Aufgabe der Erfindung ist es, ein Verfahren zur Behandlung von Oberflächen von als Lichtquellen in Fahrzeugleuchten vorgesehenen OLEDs bereitzustellen, welches eine Steigerung der Verwendbarkeit von verfügbaren OLEDs als Lichtquellen in Fahrzeugleuchten sicherstellt und damit eine Verbesserung der Verfügbarkeit von OLEDs für Fahrzeuganwendungen gewährleistet. Darüber hinaus ist es eine Aufgabe der Erfindung, ein mit einer eine entsprechend behandelte Oberfläche aufweisende OLED als Lichtquelle ausgestattetes Leuchtmittel für eine Fahrzeugleuchte anzugeben.

Die Aufgabe wird jeweils durch die Merkmale eines der unabhängigen Ansprüche gelöst. Vorteilhafte Ausführungsformen sind in den Ansprüchen, den Zeichnungen sowie in der nachfolgenden Beschreibung, einschließlich der zu den Zeichnungen zugehörigen, wiedergegeben.

Die Erfindung löst die gestellte Aufgabe durch eine Veredelung beziehungsweise einen oder mehrere Veredelungsprozesse in Bezug auf das optische Erscheinungsbild, wodurch Fehlstellen innerhalb der Leuchtflächen unter anderem auch von ansonsten nicht verwendbaren OLEDs nicht mehr auffallen.

Ein erster Gegenstand der Erfindung betrifft demnach ein Verfahren zur Behandlung wenigstens einer Oberfläche einer als Lichtquelle in einer Fahrzeugleuchte vorgesehenen OLED, insbesondere einer als Lichtquelle eines Leuchtmittels für eine Fahrzeugleuchte vorgesehenen OLED, zum Zwecke einer Steigerung der Verwendbarkeit von verfügbaren OLEDs als Lichtquellen in Fahrzeugleuchten.

Die OLED weist eine zur vorderseitigen Lichtabstrahlung vorgesehene Leuchtfläche sowie eine der Leuchtfläche gegenüberliegende Rückfläche auf.

Die Rückfläche kann ebenfalls wie die Leuchtfläche zur Lichtabstrahlung vorgesehen sein. Alternativ oder zusätzlich kann sie zur Lichtumlenkung zur anschließenden Lichtauskopplung an der Leuchtfläche vorgesehen sein.

Die Leuchtfläche und die ihr gegenüberliegende Rückfläche zeichnen sich dadurch aus, dass sie von gegenüberliegenden Seiten her eine die mindestens eine Emitterschicht enthaltende Leuchtpartie der OLED bedecken.

Leucht- und Rückfläche können beispielsweise ein- oder mehrseitig an eine passive Randfläche angrenzen, unter der beziehungsweise innerhalb der sich keine Emitterschicht der OLED befindet.

Beispielsweise können die Leuchtfläche und die Rückfläche allseitig von einer umlaufenden Randfläche umgeben und hierdurch begrenzt sein.

Das Verfahren sieht eine Behandlung zumindest der Leuchtfläche und/oder der Rückfläche durch Auftragung einer oder mehrerer Strukturen wenigstens auf die Leuchtfläche und/oder der Rückfläche der OLED vor.

Die Struktur erstreckt sich dabei zumindest innerhalb des von der Leuchtfläche eingenommenen Bereichs auf der die Leuchtfläche umfassenden Oberfläche und/oder der die der Leuchtfläche gegenüberliegenden Rückfläche umfassenden Oberfläche der OLED.

Die mindestens eine Struktur erzeugt wenigstens im Warmzustand, vorzugsweise sowohl im Kalt- als auch im Warmzustand, einen Hell-Dunkel-Kontrast zumindest innerhalb der von der Leuchtfläche eingenommenen Fläche der OLED.

Die mindestens eine Struktur bildet durch den durch sie erzeugten Hell-Dunkel-Kontrast optisch dominierende Elemente.

Durch die optische Dominanz der Elemente wird von den optisch minder dominanten, eingangs erwähnten, bei gemäß den heutigen Fertigungsmethoden hergestellten OLEDs auftretenden Fehlern abgelenkt.

Das Verfahren zur Behandlung wenigstens einer Oberfläche einer als Lichtquelle in einer Fahrzeugleuchte vorgesehenen OLED, insbesondere einer als Lichtquelle eines Leuchtmittels für eine Fahrzeugleuchte vorgesehenen OLED, zum Zwecke einer Steigerung der Verwendbarkeit von verfügbaren OLEDs als Lichtquellen in Fahrzeugleuchten, sieht demnach eine Veredelung von Oberflächen von OLEDs zum Zwecke der Verwendbarmachung unter Anderem auch solcher OLEDs für Fahrzeuganwendungen vor, die bislang für diesen Zweck nicht einsetzbar sind und aussortiert werden müssen, indem wenigstens eine Struktur auf die Leuchtfläche und/oder die Rückfläche aufgebracht wird, welche zumindest innerhalb der Leuchtfläche entlang dem Verlauf der Struktur einen hohen Hell-Dunkel-Kontrast zwischen solchen Partien der Leuchtfläche, die frei von der Struktur sind, und solchen Partien der Leuchtfläche, die mit der Struktur versehen sind und/oder solche Partien der Leuchtfläche, die sich in einer Projektion der Rückfläche auf die Leuchtfläche vor mit der Struktur versehenen Partien der Rückfläche auf der Leuchtfläche befinden.

Die Reihenfolge der Nennung der mit Struktur versehenen Partien und der frei von der Struktur verbleibenden Partien in Bezug zum Begriff Hell-Dunkel-Kontrast ist hierbei nicht als Zuordnung zu verstehen, wie den nachfolgenden bevorzugten Ausgestaltungen noch zu entnehmen ist. Demnach kann die Leuchtfläche je nach Art der Struktur, insbesondere je nach für die Auftragung der Struktur verwendetem Material und/oder Herstellungsweg zum Erhalt der Struktur im Bereich der Struktur heller oder dunkler erscheinen, als diejenigen Partien der Leuchtfläche, die frei von der Struktur sind.

Der Hell-Dunkel-Kontrast kann durch Strukturen aus lichtauskopplungsförderndem Material und/oder aus lichtauskopplungsunterbindendem Material erzeugt werden.

Die Struktur zeichnet sich durch eine Freilassung zumindest des selben flächenmäßigen Anteils jeweils der Leuchtfläche und/oder der Rückfläche, wie des von der Struktur eingenommenen Anteils jeweils der Leuchtfläche und/oder der Rückfläche aus.

Dabei ist bevorzugt zumindest der selbe Flächenanteil jeweils der Leuchtfläche und/oder der Rückfläche frei von der Struktur, wie derjenige von der Struktur eingenommene Flächenanteil.

Hierdurch kann weiterhin ein erheblicher Teil der Leuchtfläche als spiegelnde Oberfläche zur Verfügung stehen, was eine räumliche Anordnung mehrerer OLEDs hintereinander begünstigt, einhergehend mit einer besonders homogenen Lichtverteilung und -abstrahlung.

Darüber hinaus sieht die Auftragung mehrere voneinander durch Teile der mindestens einen Struktur voneinander getrennte Partien der Leuchtfläche und/oder der Rückfläche vor, die frei von der mindestens einen Struktur sind.

Das Verfahren sieht demnach eine Auftragung wenigstens einer Struktur zumindest im Bereich der Leuchtfläche der OLED auf eine die Leuchtfläche und/oder die Rückfläche umfassende Oberfläche der OLED vor, welche Struktur nur einen Teil der Leuchtfläche und/oder der dieser gegenüberliegenden Rückfläche einnimmt, die darüber hinaus mehrere voneinander durch Teile der Struktur voneinander getrennte Partien aufweist, die frei von der Auftragung sind.

Bevorzugt umfasst die Struktur eine Linienstruktur.

Zusätzlich lässt sich durch eine entsprechende visuelle Gestaltung der Struktur ein virtueller Tiefeneffekt erzeugen, welcher die Aufmerksamkeit nachfolgender Verkehrsteilnehmer auf die entsprechend verwirklichte Lichtfunktion zieht, einhergehend mit einer Erhöhung der Verkehrssicherheit.

Die Linienstruktur kann demnach eine optische Tiefenwirkung nachbilden.

Die Struktur kann hierzu eine geometrische Anordnung von Linien umfassen.

Die Struktur kann beispielsweise zumindest eine regelmäßige geometrische Anordnung aus zumindest abschnittsweise parallel verlaufenden Linien umfassen.

Alternativ oder zusätzlich kann die Struktur zumindest abschnittsweise eine geometrische Anordnung von Linien umfassen, die einem gemeinsamen Fluchtpunkt oder zwei oder mehreren Fluchtpunkten zustreben.

Wie bereits erwähnt wird der Hell-Dunkel-Kontrast durch Strukturen aus lichtauskopplungsförderndem Material und/oder aus lichtauskopplungsunterbindendem Material erzeugt werden.

Die Auftragung der Struktur kann durch ein vorder- und/oder rückseitiges, partielles Aufbringen eines die Lichtauskopplung aus der Leuchtfläche der OLED erhöhenden Materials erfolgen.

Durch eine Struktur aus lichtauskopplungsförderndem Material wird sowohl die Lichtauskopplung aus der OLED verbessert, als auch das Wärmemanagement von mit einer entsprechenden OLED ausgestatteten Fahrzeugleuchte verbessert.

Die Lichtauskopplung kann beispielsweise durch eine im Bereich der Leuchtfläche der vorderseitigen Oberfläche vorgesehene Verringerung der Differenz der Brechungsindizes beim Übertritt von Licht zwischen Materialien mit unterschiedlichem Brechungsindex erhöht werden.

So kann das Verfahren beispielsweise vorsehen, eine der Struktur entsprechende Geometrie aufweisende Diffusorfolie auf die die Leuchtfläche umfassende Oberfläche der OLED aufzutragen.

Die Diffusorfolie kann hierbei zunächst entsprechend der Geometrie der Struktur ausgeschnitten und dann auf die die Leuchtfläche umfassende Oberfläche aufgebracht werden, entsprechend einer additiven Auftragung.

Alternativ kann zunächst die Diffusorfolie vollflächig auf die die Leuchtfläche umfassende Oberfläche aufgebracht werden und anschließend entsprechend der Geometrie der Struktur von der Oberfläche entfernt werden. Dies entspricht einer subtraktiven Auftragung durch Freilegung von freizuhaltenden Partien unter Entfernung einer zuvor aufgebrachten Beschichtung und/oder Auftragung.

Die Lichtauskopplung kann alternativ oder zusätzlich durch eine rückseitig im Bereich der Rückfläche vorgesehene Struktur erhöht werden, welche eine Verkleinerung des Auftreffwinkels des von der Rückfläche zur Leuchtfläche reflektierten, von der oder den Emitterschichten der OLED im Warmzustand abgestrahlten Lichts auf die Leuchtfläche zum Lot hin bewirkt, wodurch der durch Totalreflexion innerhalb der OLED hin- und hergeworfene Anteil des Lichts verringert wird und die Lichtauskopplung insgesamt verbessert wird.

Werden am Übergang vom Substrat zur die OLED umgebenden Luft optisch wirksame - strukturierte - Oberflächen vorgehalten und/oder zusätzlich ein vorteilhafterer Brechzahlübergang geschaffen, kann mehr Licht aus den OLEDs auskoppeln und die Leuchtdichte und Auskoppeleffizienz der OLED wird gesteigert. Dies hilft auch für die Erhöhung der Lebensdauer und wirkt der OLED-Alterung entgegen, indem es diese verlangsamt.

Dies ist dadurch begründet, dass OLEDs für Fahrzeuganwendungen den nachteiligen Effekt aufweisen, dass aufgrund in deren Innerem auftretender TotalReflexion das abhängig vom kurz als Stackaufbau und -strukturierung bezeichneten Aufbau der Stapel meist nicht gerichtete Licht ihrer einen oder mehreren Emitterschichten sich zu einem signifikanten Teil in dem beispielsweise als Glas- oder Kunststoffträger ausgeführten Substrat fängt und/oder zurück in die organischen Schichten reflektiert und dadurch innerhalb der OLED absorbiert wird. Dabei wird die Lichtenergie in Wärme umgewandelt, was zusätzlich nachteilig ist, da ein besseres Wärmemanagement in einer geschlossenen Fahrzeugleuchte aufgrund der OLED-Eigenerwärmung nötig ist und zusätzlich die Alterung der OLEDs mit steigender Temperatur signifikant ansteigt, einhergehend mit einer sinkenden Lebensdauer der OLED.

Darüber hinaus ergibt sich eine unerwünschte erhöhte Auskopplung von Licht an den Substraträndern.

Eine Struktur aus lichtauskopplungsförderndem Material, welche die Leucht- und/oder Rückfläche der OLED teilweise einnimmt, verringert die genannten Nachteile, einhergehend mit dem Vorteil einer Qualitätssteigerung durch die von Fehlern ablenkende Struktur.

Wird durch eine beispielsweise in Folien- und/oder Drucktechnik hergestellte Struktur aus lichtauskopplungsförderndem Material die Auskoppeleffizienz erhöht, lässt sich außerdem die eingebrachte Leistung in die OLEDs verringern. Hierdurch kann die selbe Lichtstärke mit einer kleineren Stromstärke oder mit der selben Stromstärke eine höhere Lichtstärke erhalten werden. Auch dies wirkt sich positiv auf die Lebensdauer und Alterung aus, da die auf die OLEDs einwirkenden Belastungen entsprechend sinken.

Die von der Struktur aus lichtauskopplungsförderndem Material bedeckten Bereiche der Leucht- und/oder Rückfläche bilden im Warmzustand heller leuchtende Zonen und erscheinen einem Betrachter dominanter und lenken zusätzlich noch von kleinen unscheinbareren Fehlern, wie etwa Dark Spots, Bright Spots, Pixel Shrinkage und/oder Wolken ab.

Die Auftragung der Struktur erfolgt durch vorder- und/oder rückseitiges Aufbringen eines die Lichtauskopplung aus der Leuchtfläche der OLED abschwächenden oder gar verhindernden Materials.

Erfindungsgemäß enthält das Leuchtmittel eine Kombination von Strukturen aus lichtauskopplungsförderndem Material in Form mindestens einer Auskoppelerhöhungsstruktur und aufgebrachtem lichtauskopplungsabschwächenden oder gar -verhindernden, beispielsweise absorbierenden Material.

Durch eine durch die partielle Auftragung der Struktur auf wenigstens eine Oberfläche der OLED hergestellte partielle Beschichtung oder Applikation können optische Mängel der Leuchtflächen von OLEDs sowohl im Kalt-, als auch im Warmzustand in Kauf genommen werden, wodurch mehr OLEDs aus der Produktion verfügbar gemacht werden können, somit eine Kostensenkung durch eine Verwendbarkeit einer größeren Menge aller hergestellten OLEDs erreicht wird, und die Umwelt durch eine geringere Ausschussquote, weniger Reklamationsfälle und eine geringere Austauschquote einhergehend mit einem geringeren Ressourcenverbrauch geschont wird. Aller Voraussicht nach sinkt hierdurch auch der Preis der verfügbaren OLEDs.

Durch die Behandlung der Oberfläche durch Auftragung einer Struktur mit vorsätzlich erzeugten Helligkeitsunterschieden innerhalb der Leuchtfläche werden die einleitend genannten, bei OLEDs auftretenden Fehler zwar nicht ausgemerzt, jedoch wird das Auge des Betrachters durch die Struktur und durch die durch sie erzeugten Helligkeitsunterschiede sowohl im Kalt-, als auch im Warmzustand abgelenkt.

Hierdurch werden die bei gemäß den heutigen Fertigungsmethoden hergestellten OLEDs innerhalb der Leuchtfläche auftretenden Fehler nicht mehr wahrgenommen, ohne sie zu kaschieren. Dadurch wird vermieden, dass die bislang einen Reklamationsgrund aufgrund eines negativen Qualitätseindrucks darstellenden, bei der überwiegenden Mehrzahl der hergestellten OLEDs auftretenden, eingangs genannten Fehler auffallen. Hierdurch werden auch solche gemäß den heutigen Fertigungsmethoden hergestellten OLEDs nunmehr als Lichtquellen in Fahrzeugleuchten verwendbar, die bislang aufwändig aussortiert werden mussten.

Der erste Gegenstand der Erfindung kann demnach alternativ formuliert werden zu einem Verfahren zur Steigerung der Verwendbarkeit von verfügbaren OLEDs als Lichtquellen in Fahrzeugleuchten.

Die Steigerung der Verwendbarkeit von verfügbaren OLEDs als Lichtquellen in Fahrzeugleuchten wird demnach durch die beschriebene Behandlung von Oberflächen von als Lichtquellen in Fahrzeugleuchten vorgesehenen OLEDs vermittels Auftragung einer oder mehrerer einen Hell-Dunkel-Kontrast zumindest im Bereich der Leuchtfläche erzeugender Strukturen wenigstens auf die Leuchtfläche und/oder die Rückfläche der OLED erreicht, von welcher Struktur zumindest die Hälfte der Leuchtfläche frei ist, welche Struktur darüber hinaus zumindest jeweils zwei Partien der Leuchtfläche und/oder der Rückfläche einnimmt, und wobei die Struktur die Leuchtfläche und/oder die Rückfläche im mehrere Partien unterteilt, die frei von der Struktur sind.

Die Erfindung sieht somit vor, durch Aufbringen von optisch dominierenden Elementen auf der die Leuchtfläche und/oder die dieser gegenüberliegenden Rückfläche umfassenden Oberfläche einer zur Verwendung als Lichtquelle in einer Fahrzeugleuchte vorgesehenen OLED, von einigen der eingangs genannten Fehler, insbesondere Dark Spots und Bright Spots, Pixel Shrinkage sowie Wolken abzulenken. Hierdurch wird der Qualitätseindruck erhöht und vermieden, dass die genannten Fehler die Qualität beeinträchtigen und an der fertigen Fahrzeugleuchte eine Mangelbeseitigung gefordert wird. Durch die optische Dominanz der Elemente wird von den optisch minder dominanten Fehlern abgelenkt.

Erreicht wird dieser kaschierenden Effekt durch optische- und/oder prismatische und/oder beispielsweise mikrooptische und/oder ähnliche, beispielsweise grafische Strukturen, die subtraktiv durch Entfernung und/oder additiv durch Hinzufügung hergestellt werden können, wie etwa beispielsweise mikroprismatische Strukturen, Ätzungen oder Sandstrahloberflächen. Durch einige dieser Veredelungsprozesse erfährt die OLED zusätzlich eine Steigerung ihrer Auskopplungs-Effizienz.

Auch wird die eingeschränkte Verfügbarkeit von OLED-Herstellern für automotive OLEDs vergrößert, da mit dieser Erfindung auch OLED-Hersteller für die Anwendung in Betracht gezogen werden können, die aktuell noch mit Dark Spots Probleme haben. Damit hilft die Erfindung auch bei der Befähigung neuer OLED-Lieferanten und dem Einsatz deren OLEDs für automotive Anwendungen.

Es ist ersichtlich, dass die Erfindung zur Behebung der Nachteile des Standes der Technik und zur vollständigen Lösung der gestellten Aufgabe einhergehend mit einer Erhöhung der zur Verfügung stehenden OLEDs und einer hiermit verbundenen Kostenreduktion die Aufbringung mindestens einer nur Teile der Leuchtfläche einnehmenden Struktur vorsieht, welche einen Hell-Dunkel-Kontrast erzeugt, der von den negativen Qualitätseindrücken innerhalb der OLED-Leuchtfläche ablenkt.

Ein zweiter Gegenstand der Erfindung betrifft ein zur Erfüllung einer Lichtfunktion einer Fahrzeugleuchte oder zum Beitrag einer vorgegebenen Lichtverteilung einer Lichtfunktion einer Fahrzeugleuchte vorgesehenes Leuchtmittel für eine Fahrzeugleuchte.

Jede Fahrzeugleuchte erfüllt je nach Ausgestaltung eine oder mehrere Aufgaben bzw. Funktionen. Zur Erfüllung jeder Aufgabe bzw. Funktion ist eine Lichtfunktion der Fahrzeugleuchte vorgesehen. Lichtfunktionen sind beispielsweise bei einer Ausgestaltung als Scheinwerfer eine die Fahrbahn ausleuchtende Funktion, oder bei einer Ausgestaltung als Signalleuchte eine Signalfunktion, wie beispielsweise eine Wiederholblinklichtfunktion zur Fahrtrichtungsanzeige oder eine Bremslichtfunktion zur Anzeige einer Bremstätigkeit, oder z.B. einer Begrenzungslichtfunktion, wie etwa einer Rücklichtfunktion, zur Sicherstellung einer Sichtbarkeit des Fahrzeugs bei Tag und/oder Nacht, wie etwa bei einer Ausgestaltung als Heckleuchte oder Tagfahrleuchte. Beispiele für Fahrzeugleuchten sind am Fahrzeugbug, an den Fahrzeugflanken und/oder an den Seitenspiegeln sowie am Fahrzeugheck angeordnete Blinkleuchten, Ausstiegsleuchten, beispielsweise zur Umfeldbeleuchtung, Begrenzungsleuchten, Bremsleuchten, Nebelleuchten, Rückfahrleuchten, sowie typischerweise hoch gesetzte dritte Bremsleuchten, so genannte Central, High-Mounted Braking Lights, Tagfahrleuchten, Scheinwerfer und auch als Abbiege- oder Kurvenlicht verwendete Nebelscheinwerfer, sowie Kombinationen hiervon.

Jede Lichtfunktion muss dabei eine beispielsweise gesetzlich vorgegebene Lichtverteilung erfüllen. Die Lichtverteilung legt dabei mindestens einzuhaltende, umgangssprachlich als Helligkeit bezeichnete Lichtströme in zumindest einzuhaltenden Raumwinkelbereichen fest.

Das Leuchtmittel umfasst zumindest eine Lichtquelle.

Das Leuchtmittel weist mindestens eine nach einem zuvor beschriebenen Verfahren behandelte und/oder veredelte OLED als wenigstens eine seiner Lichtquellen auf.

Wenigstens einer Lichtquelle des Leuchtmittels können ein oder mehrere zur Ausformung einer Lichtverteilung beitragende Optikelemente zur Lichtlenkung zugeordnet sein.

Das Leuchtmittel kann einzelne oder eine Kombination der zuvor und/oder nachfolgend in Verbindung mit dem Verfahren beschriebene Merkmale aufweisen, ebenso wie das Verfahren einzelne oder eine Kombination mehrerer zuvor und/oder nachfolgend in Verbindung mit dem Leuchtmittel beschriebene Merkmale aufweisen und/oder verwirklichen kann.

Sowohl das Leuchtmittel, als auch alternativ oder zusätzlich das Verfahren können alternativ oder zusätzlich einzelne oder eine Kombination mehrerer einleitend in Verbindung mit dem Stand der Technik und/oder in einem oder mehreren der zum Stand der Technik erwähnten Dokumente und/oder in der nachfolgenden Beschreibung zu den in den Zeichnungen dargestellten Ausführungsbeispielen beschriebene Merkmale aufweisen.

Zusätzliche, über die vollständige Lösung der gestellten Aufgabe und/oder über die voran zu den einzelnen Merkmalen genannten Vorteile hinausgehende Vorteile gegenüber dem Stand der Technik sind nachfolgend aufgeführt.

Insbesondere stellt die Erfindung ein Verfahren zur Qualitätssteigerung von mit OLEDs als Lichtquellen ausgestatteten Leuchtmitteln zur Verfügung, einhergehend mit einer Steigerung der Verfügbarkeit verwendbarer OLEDs als Lichtquellen in Fahrzeugleuchten und einhergehend mit einer verringerten Ausschussquote und damit verringerten Kosten.

Ein weiterer Vorteil der Erfindung ist, dass durch kleinere Anpassung oder hinzufügen der Struktur leicht ein weitestgehend neues Erscheinungsbild der OLED und somit einer hiermit als Lichtquelle ausgestatteten Fahrzeugleuchte geschaffen werden kann. Dadurch können kostengünstig und einfach für neue Fahrzeugleuchtenvarianten beispielsweise für Facelifts von Fahrzeugen, Tuningteilen und Individualisierungen neue Designs geschaffen werden. Auch sind viele unterschiedlich gestaltete OLEDs mit gleichem OLED-Ausgangsdesign und damit gleicher Grundgeometrie leicht umsetzbar, da der Prozess des beispielsweise durch Aufbringen verwirklichten Auftragens der Strukturen eine vergleichsweise hohe Flexibilität zulässt.

Zusätzlich ergeben sich mit der Erfindung Vorteile bezüglich der Möglichkeit einer scheinbar dreidimensionalen Ausgestaltung anhand einer eine räumliche Struktur nachbildenden und/oder vortäuschenden zweidimensionalen Ausgestaltung der Struktur. Dies gilt sowohl für ebene, als auch für gewölbte OLEDs.

Weitere Vorteile gegenüber dem Stand der Technik sind, dass die in ihrer Anschaffung kostenintensiven Werkzeuge zur Herstellung der OLEDs einschließlich der gegebenenfalls optimierten Herstellungsprozesse gleich bleiben. Es ist nur nötig die Struktur auf der OLED anzupassen.

Da dieser Prozessschritt ganz zum Schluss bei der OLED-Herstellung stattfindet nimmt es keinen Einfluss und ist unabhängig auf die vorangegangenen Prozesse.

Die beschriebenen Strukturen in die Leuchtfläche und/oder Rückfläche einzubringen ist grundsätzlich auch anderweitig denkbar, beispielsweise direkt bei der OLED-Herstellung. Allerdings ist dies mit erheblich höheren Kosten verbunden, da die organischen Schichten strukturiert aufgebracht und/oder mit einem weiteren komplizierten und kostenintensiven Prozess, wie etwa einer Laserstrukturierung strukturiert werden müssen.

Hierbei würde die Struktur jedoch nicht in vergleichbarer Intensität und Anmutung im Kaltdesign, wie sie bei beispielsweise schwarzem aufgebrachtem Material an der Außenseite erkennbar ist, nicht vorhanden sein. Da allerdings hierbei auch mehr Ecken und Kanten an den Leuchtflächen auftreten ist die Wahrscheinlichkeit eines Auftretens von Pixel Shrinkage und weiteren Dark Spots noch vergrößert, da sich an diesen Bereichen höhere Stromdichten ergeben, wodurch wiederum die organischen Schichten stärker belastet und somit schneller altern und schneller beschädigt werden.

Die Erfindung wird nachfolgend anhand von in der Zeichnung dargestellter Ausführungsbeispiele näher erläutert. Die Größenverhältnisse der einzelnen Elemente zueinander in den Figuren entsprechen nicht immer den realen Größenverhältnissen, da einige Formen vereinfacht und andere Formen zur besseren Veranschaulichung vergrößert im Verhältnis zu anderen Elementen dargestellt sind. Für gleiche oder gleich wirkende Elemente der Erfindung werden identische Bezugszeichen verwendet. Ferner werden der Übersicht halber nur Bezugszeichen in den einzelnen Figuren dargestellt, die für die Beschreibung der jeweiligen Figur erforderlich sind. Die dargestellten Ausführungsformen stellen lediglich Beispiele dar, wie die Erfindung ausgestaltet sein kann und stellen keine abschließende Begrenzung dar. Es zeigen in schematischer Darstellung:

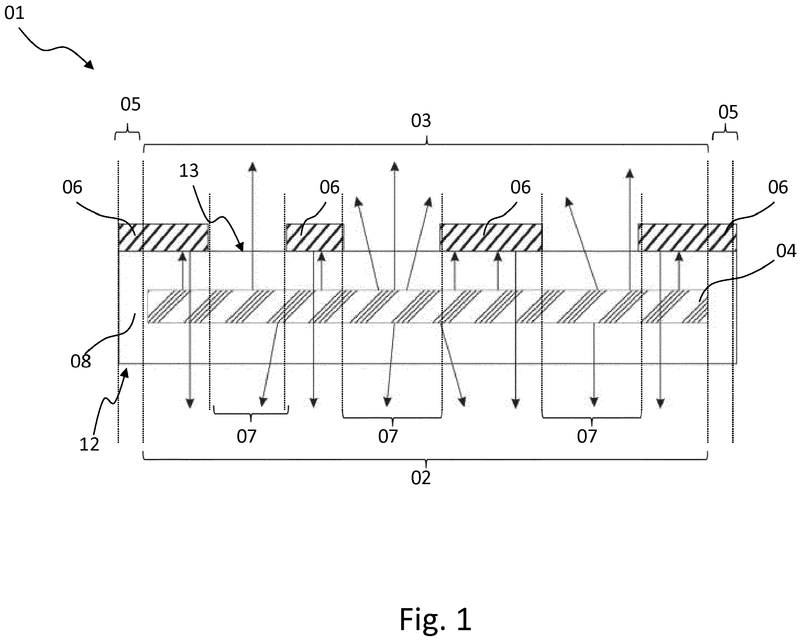

- Fig. 1: einen Querschnitt durch eine zur Auftragung einer Struktur einseitig strukturiert bedampfte OLED mit unterschiedlichem Erscheinungsbild der Abstrahlung nach beiden Seiten (hier: oben: Rückfläche, unten: Leuchtfläche), wobei die in Fig. 1 gezeigte OLED nicht unter die Ansprüche fällt.

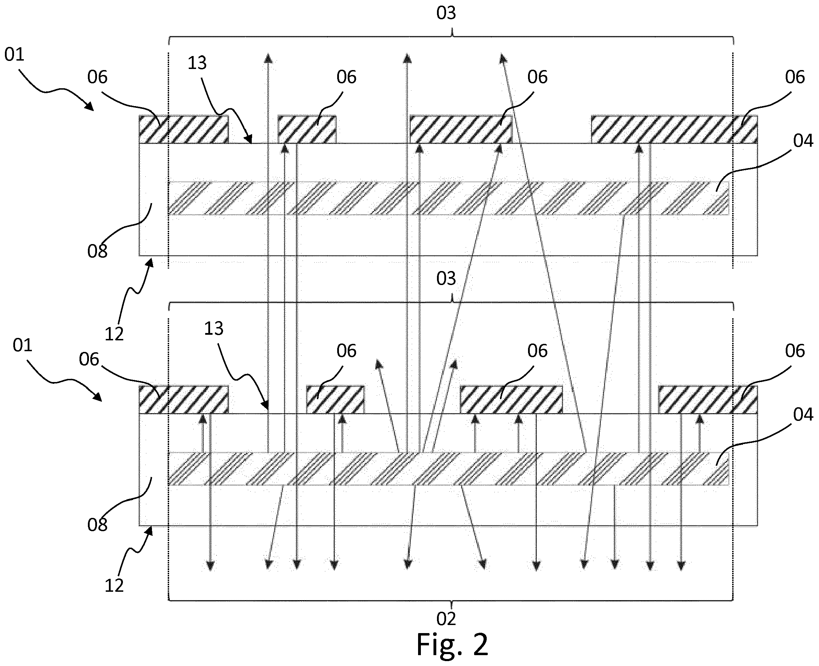

- Fig. 2: einen Querschnitt durch zwei zur Auftragung einer Struktur einseitig unterschiedlich strukturiert bedampfte OLEDs mit unterschiedlichem Erscheinungsbild der Abstrahlung nach beiden Seiten (hier: oben: Rückfläche, unten: Leuchtfläche), wobei eine zusätzliche Tiefenwirkung durch teilweises Durchstrahlen der OLEDs entsteht. Die in Fig. 2 gezeigte OLED fällt nicht unter die Ansprüche.

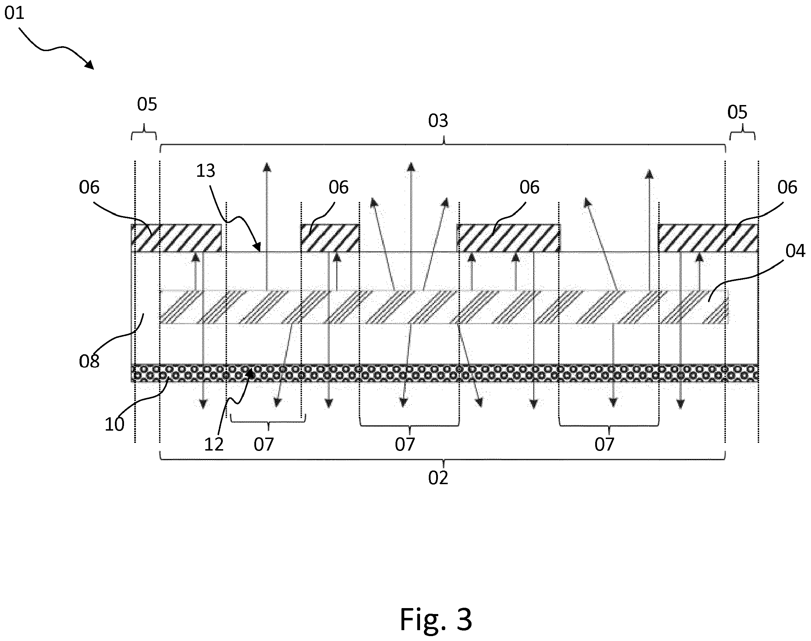

- Fig. 3: einen Querschnitt durch eine zur Auftragung einer Struktur einseitig strukturiert bedampfte OLED mit unterschiedlichem Erscheinungsbild der Abstrahlung nach beiden Seiten (hier: oben: Rückfläche, unten: Leuchtfläche) mit einer auf der Leuchtfläche vollflächig aufgebrachten, als Auskoppelfolie ausgeführten Schicht aus lichtauskopplungsförderndem Material, um dort die Lichtauskopplung zu erhöhen, und einer auf der Rückfläche aufgebrachten, durch die strukturierte Bedampfung hergestellte Struktur, welche zumindest im Warmzustand einen Hell-Dunkel-Kontrast wenigstens innerhalb der von der Leuchtfläche eingenommenen Fläche der OLED erzeugt.

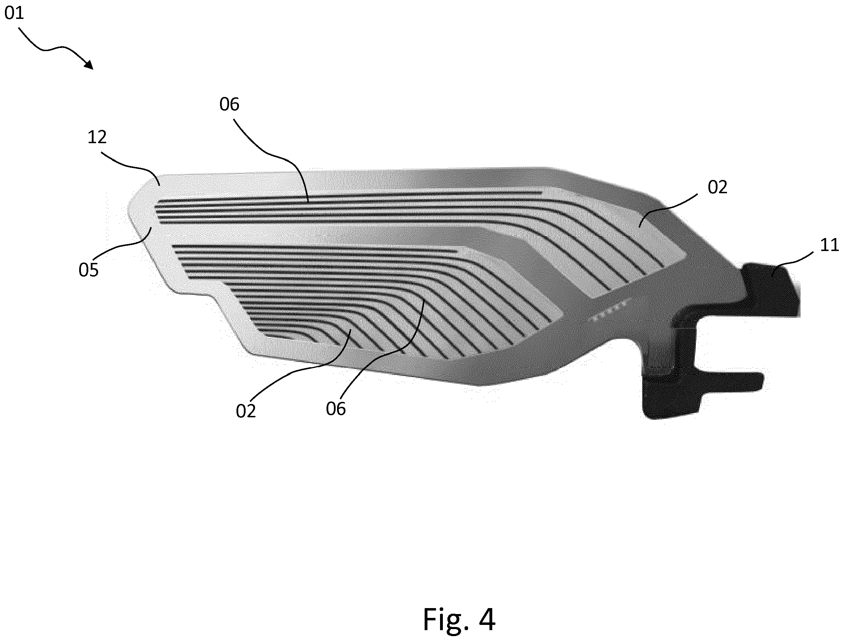

- Fig. 4: ein erstes Ausführungsbeispiel einer die Leuchtfläche umfassenden Oberfläche einer OLED, welche Oberfläche zumindest im Bereich der Leuchtfläche durch Auftragung einer Struktur aus lichtauskopplungsförderndem Material oder aus lichtauskopplungsabschwächendem oder gar -verhinderndem, beispielsweise absorbierendem, kurz lichtauskopplungsunterbindendem Material, behandelt ist, in einer Draufsicht auf die Oberfläche.

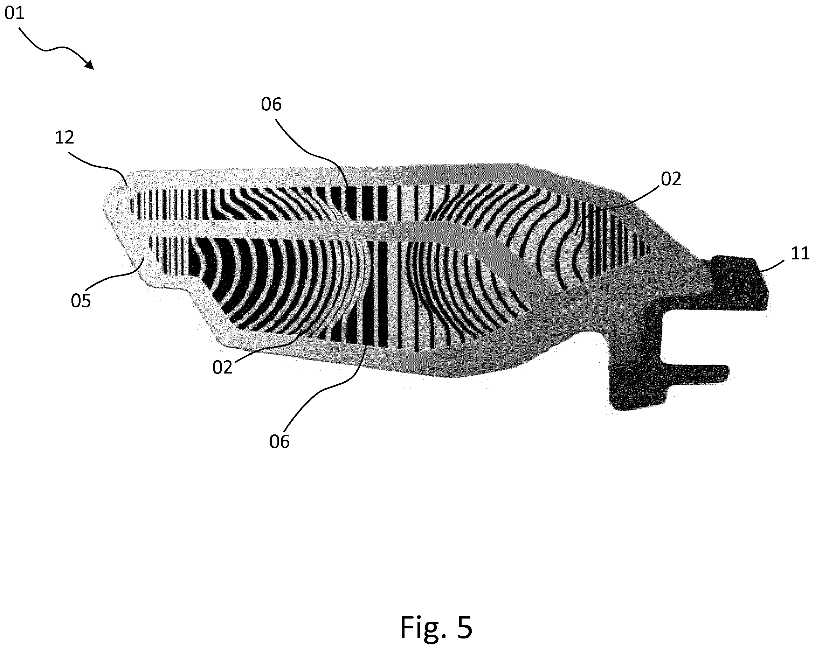

- Fig. 5: ein zweites Ausführungsbeispiel einer die Leuchtfläche umfassenden Oberfläche einer OLED, welche Oberfläche zumindest im Bereich der Leuchtfläche durch Auftragung einer beim Betrachter einen dreidimensionalen Eindruck erzeugenden Struktur aus lichtauskopplungsförderndem Material oder aus lichtauskopplungsabschwächendem oder gar -verhinderndem, beispielsweise absorbierendem, kurz lichtauskopplungsunterbindendem Material, behandelt ist, in einer Draufsicht auf die Oberfläche.

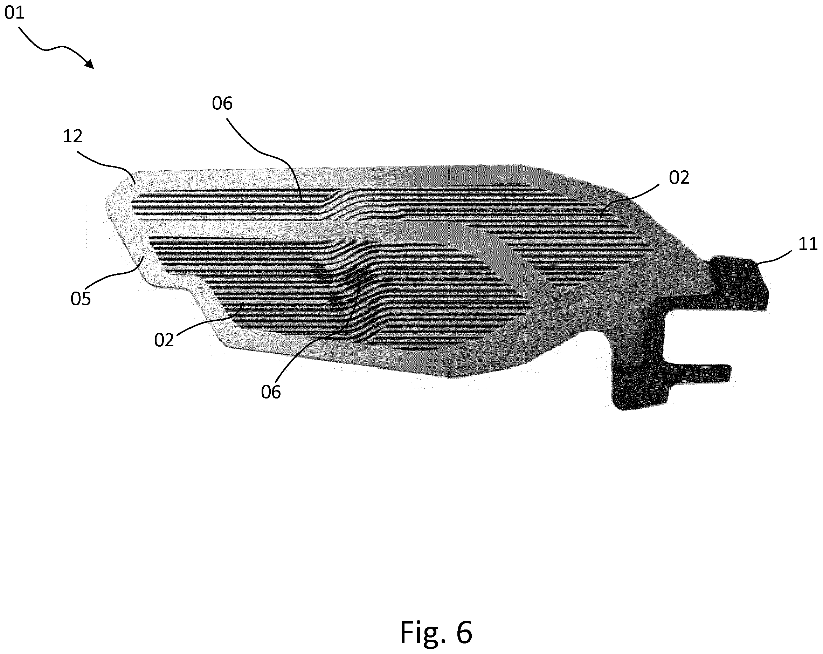

- Fig. 6: ein drittes Ausführungsbeispiel einer die Leuchtfläche umfassenden Oberfläche einer OLED, welche Oberfläche zumindest im Bereich der Leuchtfläche durch Auftragung einer beim Betrachter einen dreidimensionalen Eindruck erzeugenden Struktur aus lichtauskopplungsförderndem Material oder aus lichtauskopplungsabschwächendem oder gar -verhinderndem, beispielsweise absorbierendem, kurz lichtauskopplungsunterbindendem Material, behandelt ist, in einer Draufsicht auf die Oberfläche.

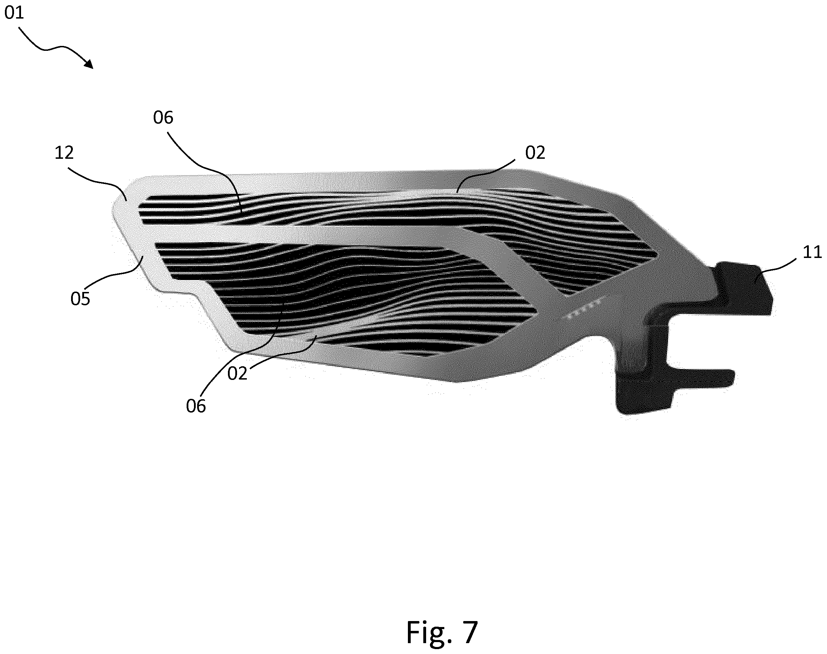

- Fig. 7: ein viertes Ausführungsbeispiel einer die Leuchtfläche umfassenden Oberfläche einer OLED, welche Oberfläche zumindest im Bereich der Leuchtfläche durch Auftragung einer beim Betrachter einen dreidimensionalen Eindruck erzeugenden Struktur aus lichtauskopplungsförderndem Material oder aus lichtauskopplungsabschwächendem oder gar -verhinderndem, beispielsweise absorbierendem, kurz lichtauskopplungsunterbindendem Material, behandelt ist, in einer Draufsicht auf die Oberfläche.

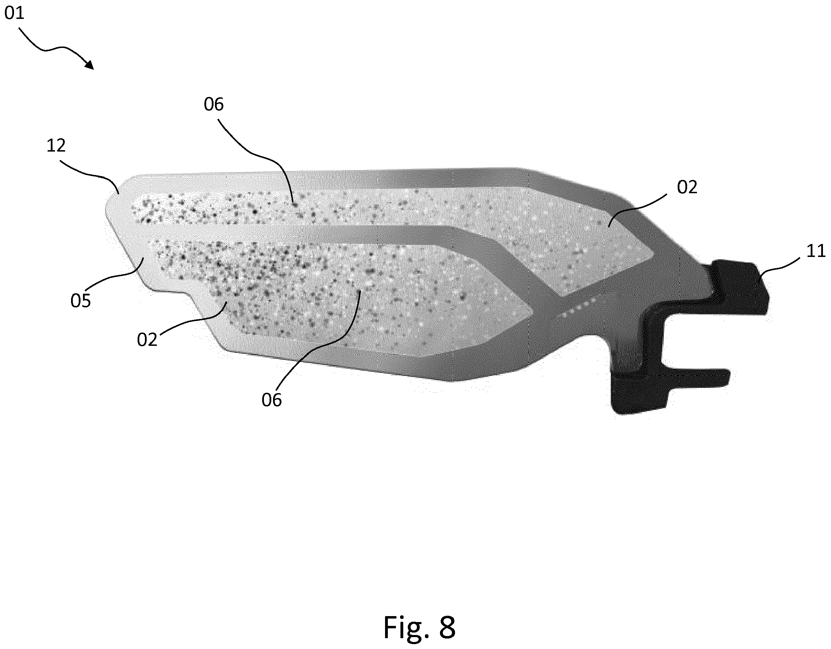

- Fig. 8: ein Ausführungsbeispiel einer die Leuchtfläche umfassenden Oberfläche einer OLED, welche Oberfläche zumindest im Bereich der Leuchtfläche durch Auftragung einer Struktur aus lichtauskopplungsförderndem Material und aus lichtauskopplungsabschwächendem oder gar -verhinderndem, beispielsweise absorbierendem, kurz lichtauskopplungsunterbindendem Material, die Dark Spots zumindest im Warmzustand nicht mehr auffindbar macht, behandelt ist, in einer Draufsicht auf die Oberfläche.

Eine in Fig. 1, Fig. 2, Fig. 3, Fig. 4, Fig. 5, Fig. 6, Fig. 7, Fig. 8 ganz oder in Teilen dargestellte OLED 01 weist eine vordere Oberfläche 12 auf, die eine zur vorderseitigen Lichtabstrahlung vorgesehene Leuchtfläche 02 umfasst, sowie eine hintere Oberfläche 13, die eine der Leuchtfläche 02 gegenüberliegende Rückfläche 03 umfasst.

Die Leuchtfläche 02 und die ihr gegenüberliegende Rückfläche 03 zeichnen sich dadurch aus, dass sie von gegenüberliegenden Seiten her eine die mindestens eine Emitterschicht 04 enthaltende Leuchtpartie der OLED 01 bedecken.

Leuchtfläche 02 und Rückfläche 03 können beispielsweise ein- oder mehrseitig an eine passive Randfläche 05 angrenzen, unter der beziehungsweise innerhalb der sich keine Emitterschicht 04 der OLED 01 befindet.

Beispielsweise können die Leuchtfläche 02 und die Rückfläche 03 allseitig von einer umlaufenden Randfläche 05 umgeben und hierdurch begrenzt sein.

Die Rückfläche 03 kann ebenfalls wie die Leuchtfläche 02 zur Lichtabstrahlung vorgesehen sein. Alternativ oder zusätzlich kann die Rückfläche 03 zur Lichtumlenkung zur anschließenden Lichtauskopplung an der Leuchtfläche 02 vorgesehen sein.

Jede der in Fig. 1, Fig. 2, Fig. 3, Fig. 4, Fig. 5, Fig. 6, Fig. 7, Fig. 8 ganz oder in Teilen dargestellten OLEDs 01 weist auf zumindest einer ihrer Oberflächen 12, 13 jeweils mindestens eine wenigstens innerhalb der von der Leuchtfläche 02 und/oder der Rückfläche 03 eingenommenen (Teil-) Flächen beziehungsweise Bereiche der die Leuchtfläche 02 und/oder der Rückfläche 03 umfassenden Oberflächen 12, 13 aufgebrachte beziehungsweise sich wenigstens innerhalb der von der Leuchtfläche 02 und/oder der Rückfläche 03 eingenommenen Bereiche erstreckende Struktur 06 auf.

Die Struktur 06 besteht aus einem die Lichtauskopplung aus der Leuchtfläche 02 der OLED 01 abschwächenden und/oder gar verhindernden Material oder aus einem die Lichtauskopplung aus der Leuchtfläche 02 der OLED 01 befördernden beziehungsweise erhöhenden Material.

Die Struktur 06 erzeugt wenigstens im Warmzustand der OLED 01, bei dem ihre Emitterschicht 04 Licht abstrahlt, bevorzugt auch im Warmzustand, in dem keine Lichtabstrahlung der Emitterschicht 04 stattfindet, einen Hell-Dunkel-Kontrast zumindest innerhalb der von der Leuchtfläche 02 eingenommenen (Teil-) Fläche der die Leuchtfläche 02 umfassenden Oberfläche 12 der OLED 01.

Die Struktur 06 ist zumindest innerhalb des von der Leuchtfläche 02 eingenommenen Bereichs auf der die Leuchtfläche 02 umfassenden Oberfläche 12 und/oder der die der Leuchtfläche 02 gegenüberliegenden Rückfläche 03 umfassenden Oberfläche 13 der OLED 01 angeordnet. Die Struktur 06 erstreckt sich somit zumindest innerhalb des von der Leuchtfläche 02 eingenommenen Bereichs auf der die Leuchtfläche 02 umfassenden Oberfläche 12 und/oder der die der Leuchtfläche 02 gegenüberliegenden Rückfläche 03 umfassenden Oberfläche 13 der OLED 01.

Die mindestens eine Struktur 06 kann mehrere voneinander durch Teile der Struktur voneinander getrennte Partien 07 aufweisen, die frei von der mindestens einen Struktur 06 sind.

Alternativ oder zusätzlich kann die mindestens eine Struktur 06 mehrere voneinander durch Partien 07, die frei von der mindestens einen Struktur sind, voneinander getrennte Teile aufweisen.

Die in Fig. 1, Fig. 2, Fig. 3, Fig. 4, Fig. 5, Fig. 6, Fig. 7, Fig. 8 ganz oder in Teilen dargestellten OLEDs 01 sind einzeln (Fig. 1, Fig. 3, Fig. 4, Fig. 5, Fig. 6, Fig. 7, Fig. 8) oder in Kombination miteinander (Fig. 2) als Lichtquellen in Fahrzeugleuchten vorgesehen.

Um als Lichtquelle in einer Fahrzeugleuchte vorgesehen zu werden, ist eine voranstehend beschriebene und nach einem nachfolgend noch beschriebenen Verfahren behandelte OLED 01 bevorzugt ein durch eine Lichtquelle gebildeter Teil eines Leuchtmittels zur Erfüllung einer Lichtfunktion einer Fahrzeugleuchte oder zum Beitrag einer vorgegebenen Lichtverteilung einer Lichtfunktion einer Fahrzeugleuchte mit mindestens einer Lichtquelle.

Zum Erhalt einer zuvor beschriebenen OLED 01 wird eine konventionelle, einfach verfügbare OLED 01 gemäß eines nachfolgend beschriebenen erfindungsgemäßen Verfahrens zur Behandlung wenigstens einer Oberfläche 12, 13 einer OLED 01 veredelt.

Das Verfahren sieht eine Behandlung zumindest der die Leuchtfläche 02 und/oder die Rückfläche 03 umfassenden Oberflächen 12, 13 der OLED 01 durch Auftragung einer oder mehrerer Strukturen 06 wenigstens auf die von der Leuchtfläche 02 und/oder der Rückfläche 03 eingenommenen Bereiche der Oberfläche 12, 13 der OLED 01 vor.

Die Struktur 06 erzeugt wenigstens im Warmzustand, bevorzugt sowohl im Kaltals auch im Warmzustand, einen Hell-Dunkel-Kontrast zumindest innerhalb der von der Leuchtfläche 02 eingenommenen (Teil-) Fläche der Oberfläche 12 der OLED 01.

Die Struktur 06 wird zumindest innerhalb des von der Leuchtfläche 02 eingenommenen Bereichs einer die Leuchtfläche 02 vorder- oder rückseitig bedeckenden (Teil-) Fläche einer Oberfläche 12, 13 der OLED 01, nämlich der die Leuchtfläche 02 umfassenden Oberfläche 12 und/oder der die der Leuchtfläche 02 gegenüberliegenden Rückfläche 03 umfassenden Oberfläche 13 der OLED 01 aufgetragen, so dass sich die Struktur 06 zumindest innerhalb des von der Leuchtfläche 02 eingenommenen Bereichs auf der die Leuchtfläche 02 umfassenden Oberfläche 12 und/oder der die der Leuchtfläche 02 gegenüberliegenden Rückfläche 03 umfassenden Oberfläche 13 der OLED 01 erstreckt.

Die Auftragung sieht zum Erhalt des Hell-Dunkel-Kontrasts an der fertig behandelten Oberfläche 12, 13 der OLED 01:
- mehrere voneinander durch Teile der mindestens einen Struktur 06 voneinander getrennte Partien 07 vor, die frei von der mindestens einen Struktur 06 sind, und/oder
- mehrere voneinander durch Partien 07, die frei von der mindestens einen Struktur 06 sind, voneinander getrennte Teile der mindestens einen Struktur 06 vor.

Das Verfahren kann demnach eine Auftragung wenigstens einer Struktur 06 zumindest im Bereich der Leuchtfläche 02 der OLED 01 auf eine die Leuchtfläche 02 und/oder die Rückfläche 03 umfassende Oberfläche 12, 13 der OLED 01 vorsehen, welche Struktur 06 nur einen Teil der Leuchtfläche 02 und/oder der dieser gegenüberliegenden Rückfläche 03 einnimmt, und die darüber hinaus mehrere voneinander durch Teile der Struktur 06 voneinander getrennte Partien 07 aufweist, die frei von der Struktur 06 sind.

Alternativ oder zusätzlich kann die Auftragung der mindestens einen Struktur 06 auf mehrere Teile der Leuchtfläche 02 und/oder der Rückfläche 03 vorsehen, die durch eine oder mehrere Partien 07 der Leuchtfläche 02 und/oder der Rückfläche 03, die frei von der mindestens einen Struktur 06 verbleiben, voneinander getrennt sind.

Die mindestens eine Struktur 06 bildet durch den durch sie erzeugten Hell-Dunkel-Kontrast optisch dominierende Elemente.

Durch die optische Dominanz der Elemente wird von den optisch minder dominanten, eingangs erwähnten, bei gemäß den heutigen Fertigungsmethoden hergestellten OLEDs 01 auftretenden Fehlern abgelenkt.

Mit dem Verfahren wird so eine Steigerung der Verwendbarkeit von verfügbaren OLEDs 01 als Lichtquellen in Fahrzeugleuchten erzielt.

Das Verfahren zur Behandlung wenigstens einer Oberfläche 12, 13 einer als Lichtquelle in einer Fahrzeugleuchte vorgesehenen OLED 01, insbesondere einer als Lichtquelle eines Leuchtmittels für eine Fahrzeugleuchte vorgesehenen OLED 01, zum Zwecke einer Steigerung der Verwendbarkeit von verfügbaren OLEDs 01 als Lichtquellen in Fahrzeugleuchten, sieht demnach eine Veredelung von Oberflächen 12, 13 von OLEDs 01 zum Zwecke der Verwendbarmachung unter Anderem auch solcher OLEDs 01 für Fahrzeuganwendungen vor, die bislang für diesen Zweck nicht einsetzbar sind und aussortiert werden müssen. Dies wird verfahrensgemäß erreicht, indem wenigstens eine Struktur 06 auf die Leuchtfläche 02 und/oder die Rückfläche 03 aufgebracht wird, welche zumindest innerhalb der Leuchtfläche 03 entlang dem Verlauf der Struktur 06 einen hohen Hell-Dunkel-Kontrast zwischen solchen Partien 07 der Leuchtfläche 02, die frei von der Struktur 06 sind, und solchen Teilen der Leuchtfläche 02, die mit der Struktur 06 versehen sind und/oder solchen Bereichen der Leuchtfläche 02, die sich in einer Projektion der Rückfläche 03 auf die Leuchtfläche 02 vor mit der Struktur 06 versehenen Teilen der Rückfläche 03 auf der Leuchtfläche 02 befinden.

Die Reihenfolge der Nennung der mit Struktur 06 versehenen Teilen und der frei von der Struktur 06 verbleibenden Partien 07 in Bezug zum Begriff Hell-Dunkel-Kontrast ist hierbei nicht als Zuordnung zu verstehen, wie den nachfolgenden Ausführungen noch zu entnehmen ist. Demnach kann die Leuchtfläche 02 je nach Art der Struktur 06, insbesondere je nach für die Auftragung der Struktur 06 verwendetem Material und/oder Herstellungsweg zum Erhalt der Struktur 06 im Bereich der Struktur 06 heller oder dunkler erscheinen, als diejenigen Partien 07 der Leuchtfläche 02, die frei von der Struktur 06 sind.

Eine vorteilhafte Ausgestaltung der voranstehend beschriebenen OLED 01 und des Verfahrens zur Behandlung zumindest einer der Oberflächen 12, 13 der OLED 01 sieht bei der Auftragung der Struktur 06 eine Freilassung zumindest des selben flächenmäßigen Anteils jeweils der Leuchtfläche 02 und/oder der Rückfläche 03 von der Struktur 06, wie des von der Struktur 06 eingenommenen Anteils jeweils der Leuchtfläche 02 und/oder der Rückfläche 03 vor.

Mit anderen Worten sieht die Auftragung der Struktur 06 vor, dass an der fertig behandelten Oberfläche 12, 13 zumindest innerhalb der die Leuchtfläche 02 überdeckenden (Teil-) Fläche der die Leuchtfläche 02 umfassenden, vorderseitigen Oberfläche 12 der OLED 01 und/oder der die Rückfläche 03 umfassenden, rückseitigen Oberfläche 13 der OLED 01 der selbe Flächenanteil frei von der Struktur 06 ist, wie derjenige von der Struktur 06 eingenommene Flächenanteil.

Hierdurch kann weiterhin ein erheblicher Teil der Leuchtfläche 02 sowie eine die Leuchtfläche 02 beispielsweise umgebende oder an diese angrenzende (Rest-) Fläche der die Leuchtfläche 02 umfassenden Oberfläche 12 der OLED 01 als spiegelnde Oberfläche zur Verfügung stehen, was eine räumliche Anordnung mehrerer OLEDs 01 hintereinander begünstigt (Fig. 2), einhergehend mit einer besonders homogenen Lichtverteilung und -abstrahlung.

Die spiegelnde Anmutung kann beispielsweise unter Anderem wegen der Möglichkeit der Lichtlenkung, beispielsweise von zur Erfüllung einer anderen oder der selben Lichtfunktionen vorgesehenen oder hierzu beitragenden Lichtquellen abgestrahltem Licht, erwünscht sein.

Der Hell-Dunkel-Kontrast wird durch eine oder mehrere Strukturen 06 aus lichtauskopplungsförderndem Material und/oder aus lichtauskopplungsunterbindendem Material erzeugt werden.

So kann die Auftragung der Struktur 06 vorsehen, dass die Struktur 06 aus einem die Lichtauskopplung aus der Leuchtfläche 02 der OLED 01 abschwächenden und/oder gar verhindernden Material besteht.

Eine vorteilhafte Ausgestaltung der voranstehend beschriebenen OLED 01 und des Verfahrens zur Behandlung zumindest einer der Oberflächen der OLED 01 kann demnach vorsehen, dass die Auftragung der Struktur 06 ein beispielsweise partielles Aufbringen eines die Lichtauskopplung aus der Leuchtfläche 02 der OLED 01 abschwächenden und/oder gar verhindernden Materials auf die Leuchtfläche 02 und/oder die Rückfläche 03, beispielsweise unter Freilassung der Partien 07, die frei von der mindestens einen Struktur 06 sind, umfasst.

Hiernach kann die Auftragung der Struktur 06 ein unter Freilassung der Partien 07, die frei von der mindestens einen Struktur 06 sind partielles, vorder- und/oder rückseitiges Aufbringen eines die Lichtauskopplung aus der Leuchtfläche 02 der OLED 01 abschwächenden und/oder gar verhindernden Materials auf die Leuchtfläche 02 und/oder die Rückfläche 03 umfassen.

Die Struktur 06 kann dabei durch ein partielles Aufbringen eines die Lichtauskopplung aus der Leuchtfläche 02 der OLED 01 abschwächenden und/oder gar verhindernden Materials auf die Leuchtfläche 02 und/oder die Rückfläche 03, beispielsweise unter unmittelbarer Freilassung der Partien 07, die frei von der mindestens einen Struktur 06 sind, aufgetragen werden.

Durch eine Struktur 06 aus einem die Lichtauskopplung aus der Leuchtfläche 02 der OLED 01 abschwächenden und/oder gar verhindernden Material wird ein hoher Hell-Dunkel-Kontrast zwischen den mit der Struktur 06 versehenen Bereichen und den benachbarten Partien 07, die frei von der Struktur 06 sind, erhalten.

Die Auftragung kann beispielsweise über Tampondruck oder Siebdruck erfolgen.

Die aufgebrachte Struktur 06 aus einem die Lichtauskopplung aus der Leuchtfläche 02 der OLED 01 abschwächenden und/oder gar verhindernden Material kann bevorzugt aus Aluminium oder Kupfer oder aus einer Legierung mit diesen Werkstoffen bestehen, wodurch zusätzlich eine gute Wärmeableitung verwirklicht werden kann und die Oberfläche ähnlich einem Kühlkörper an Computerprozessoren erhöht werden kann sowie somit die Wärmeabgabe infolge von OLED 01 Eigenerwärmung gesteigert werden kann.

Auch kann eine aufgebrachte Struktur 06 aus Aluminium oder Kupfer oder aus einer Legierung mit diesen Werkstoffen zusätzlich dazu verwendet werden, Strom zu leiten. Hierdurch kann es bei entsprechender Ausgestaltung der OLED-Halterung 11 möglich sein die OLED 01 mit Hilfe der Struktur 06 nach außen hin elektrisch zu kontaktieren. Dies wäre im entfernten Sinne vergleichbar und ähnlich mit einer Ausgestaltung als Molded Interconnect Device (Spritzgegossene Schaltungsträger), kurz MID).

Im erfindungsgemäßen Verfahren und der OLED 01 in Verbindung mit einer Struktur 06 aus einem die Lichtauskopplung aus der Leuchtfläche 02 der OLED 01 abschwächenden und/oder gar verhindernden Material ist vorsehen, dass zunächst ein die Lichtauskopplung aus der Leuchtfläche 02 der OLED 01 erhöhendes Material zumindest auf die Leuchtfläche 02 und/oder die Rückfläche 03 vollflächig aufgebracht wird, und anschließend die Auftragung der Struktur 06 aus einem die Lichtauskopplung aus der Leuchtfläche 02 der OLED 01 abschwächenden und/oder gar verhindernden Material unter Freilassung der Partien 07, die frei von der mindestens einen Struktur 06 sind, erfolgt (Fig. 3).

Hierdurch wird durch eine erhöhte Lichtabstrahlung der Partien 07, die frei von der mindestens einen Struktur 06 sind, einhergehend mit keiner oder so gut wie keiner Lichtabstrahlung in denjenigen mit der Struktur 06 versehenen Teilen der Leuchtfläche 02 ein besonders hoher Hell-Dunkel-Kontrast erhalten.

Zur Verwirklichung kann gemäß einer Ausgestaltung des erfindungsgemäßen Verfahrens vorgesehen sein, zunächst in einem ersten Behandlungsschritt des Verfahrens eine Diffusorfolie 10 vollflächig vorderseitig zumindest auf die Leuchtfläche 02 einer OLED 01 aufzubringen, um deren Lichtauskoppeleffizienz zu erhöhen. Die Diffusorfolie 10 erhöht die Effizienz der Lichtabstrahlung aus der OLED 01 signifikant um etwa 50% indem sie die Lichtauskopplung aus der OLED 01, insbesondere aus deren Substrat und/oder Verkapselung 08, durch eine Verringerung der Differenz der Brechungsindizes beim Übertritt von Licht zwischen Materialien mit unterschiedlichem Brechungsindex erhöhen. Ein Nebeneffekt der Diffusorfolie 10 ist, dass hierdurch im Warmzustand kleine Dark Spots nahezu nicht mehr mit bloßem Auge zu erkennen sind.

Die Verwendung der Diffusorfolie 10 ist jedoch für sich allein nicht geeignet, durch unterschiedliche Helligkeiten innerhalb der Leuchtfläche 02 hervorgerufene negative Qualitätseindrücke abzuwenden.

Um auch von durch unterschiedliche Helligkeiten innerhalb der Leuchtfläche 02 hervorgerufenen negativen Qualitätseindrücken abzuwenden, wird kann in einem zweiten Behandlungsschritt des Verfahrens eine Struktur 06 wenigstens auf die Leuchtfläche 02 und/oder der Rückfläche 03 der OLED 01 aufgetragen, welche Struktur 06 zumindest im Warmzustand, bevorzugt sowohl im Kalt- als auch im Warmzustand, einen Hell-Dunkel-Kontrast zumindest innerhalb der von der Leuchtfläche 02 eingenommenen Fläche der OLED 01 erzeugt.

Beispielsweise kann die Struktur 06 bei einer in einem ersten Behandlungsschritt vollflächig zumindest auf die Leuchtfläche 02 aufgetragenen Diffusorfolie 10 in einem sich hieran anschließenden zweiten Behandlungsschritt ebenfalls auf die die Leuchtfläche 02 umfassende Oberfläche 12 auf die Diffusorfolie 10 aufgebracht werden.

Alternativ kann wie in Fig. 3 dargestellt die Struktur 06 auf die der mit der Diffusorfolie 10 versehenen Oberfläche 12 gegenüberliegende Oberfläche 13 aufgetragen werden.

In einem nicht erfindungsgemäßen Verfahren zum Erhalt eines besonders hohen Hell-Dunkel-Kontrasts ist vorsehen, dass in einem ersten oder in einem zweiten Behandlungsschritt im Bereich der Struktur 06 eine die Lichtauskopplung aus der Leuchtfläche 02 der OLED 01 abschwächendes und/oder gar verhinderndes Material und in einem zweiten oder in einem ersten Behandlungsschritt im Bereich der Partien 07, die frei von der Struktur 06 sind, ein die Lichtauskopplung aus der Leuchtfläche 02 der OLED 01 erhöhendes Material aufgetragen wird.

In einem nicht erfindungsgemäßen Verfahren kann die Auftragung der Struktur 06 anstelle des Aufbringens eines die Lichtauskopplung aus der Leuchtfläche 02 der OLED 01 abschwächenden und/oder gar verhindernden Materials ein beispielsweise partielles Aufbringen eines die Lichtauskopplung aus der Leuchtfläche 02 der OLED 01 erhöhenden Materials auf die Leuchtfläche 02 und/oder die Rückfläche 03, beispielsweise unter Freilassung der Partien 7, die frei von der mindestens einen Struktur 06 sind, umfassen.

Hiernach kann die Auftragung der Struktur 06 ein unter Freilassung der Partien 07, die frei von der mindestens einen Struktur 06 sind partielles, vorder- und/oder rückseitiges Aufbringen eines die Lichtauskopplung aus der Leuchtfläche 02 der OLED 01 erhöhenden Materials auf die Leuchtfläche 02 und/oder die Rückfläche 03 umfassen.

Die Struktur 06 kann mit anderen Worten alternativ zu einem die Lichtauskopplung aus der Leuchtfläche 02 der OLED 01 abschwächenden und/oder gar verhindernden Material aus einem die Lichtauskopplung aus der Leuchtfläche 02 der OLED 01 erhöhenden Material bestehen, welches durch ein partielles Aufbringen auf die Leuchtfläche 02 und/oder die Rückfläche 03, beispielsweise unter unmittelbarer Freilassung der Partien 07, die frei von der mindestens einen Struktur 06 sind, aufgetragen werden kann.

Durch eine Struktur 06 aus lichtauskopplungsförderndem Material wird sowohl die Lichtauskopplung aus der OLED 01 verbessert, als auch das Wärmemanagement von mit entsprechenden OLEDs 01 als Lichtquellen in Leuchtmitteln ausgestatteten Fahrzeugleuchten verbessert.

Werden am Übergang vom Substrat und/oder von der Verkapselung 08 zur die OLED 01 umgebenden Luft optisch wirksame - strukturierte - Oberflächen vorgehalten und/oder zusätzlich ein vorteilhafterer Brechzahlübergang geschaffen, kann mehr Licht aus den OLEDs 01 auskoppeln und die Leuchtdichte und Auskoppeleffizienz der OLED 01 wird gesteigert. Dies hilft auch für die Erhöhung der Lebensdauer und wirkt der OLED-Alterung entgegen, indem es diese verlangsamt.

Dies ist dadurch begründet, dass OLEDs 01 für Fahrzeuganwendungen den nachteiligen Effekt aufweisen, dass aufgrund in deren Innerem auftretender TotalReflexion das abhängig vom kurz als Stackaufbau und -strukturierung bezeichneten Aufbau der Stapel meist nicht gerichtete Licht ihrer einen oder mehreren Emitterschichten sich zu einem signifikanten Teil in dem beispielsweise als Glas- oder Kunststoffträger ausgeführten Substrat und/oder Verkapselung 08 fängt und/oder zurück in die organischen Schichten reflektiert und dadurch innerhalb der OLED 01 absorbiert wird. Dabei wird die Lichtenergie in Wärme umgewandelt, was zusätzlich nachteilig ist, da ein besseres Wärmemanagement in einer geschlossenen Fahrzeugleuchte aufgrund der OLED-Eigenerwärmung nötig ist und zusätzlich die Alterung der OLEDs 01 mit steigender Temperatur signifikant ansteigt, einhergehend mit einer sinkenden Lebensdauer der OLED 01.

Darüber hinaus ergibt sich eine unerwünschte erhöhte Auskopplung von Licht an den Rändern des Substrats und/oder der Verkapselung 08.

Eine Struktur 06 aus lichtauskopplungsförderndem Material, welche die Leuchtfläche 02 und/oder die Rückfläche 03 der OLED 01 teilweise einnimmt, verringert die genannten Nachteile, einhergehend mit dem Vorteil einer Qualitätssteigerung durch die von Fehlern ablenkende Struktur 06.

Wird durch eine beispielsweise in Folien- und/oder Drucktechnik hergestellte Struktur 06 aus lichtauskopplungsförderndem Material die Auskoppeleffizienz erhöht, lässt sich außerdem die zum Erhalt einer vorgegebenen Lichtabgabe erforderliche eingebrachte Leistung verringern. Hierdurch kann die selbe Lichtstärke mit einer kleineren Stromstärke oder mit der selben Stromstärke eine höhere Lichtstärke erhalten werden. Auch dies wirkt sich positiv auf die Lebensdauer und Alterung aus, da die auf die OLEDs 01 einwirkenden Belastungen entsprechend sinken.

Die von der Struktur 06 aus lichtauskopplungsförderndem Material bedeckten Bereiche der Leuchtfläche 02 und/oder der Rückfläche 03 bilden im Warmzustand im Vergleich zu benachbarten Partien 07, die frei von der Struktur 06 sind, heller leuchtende Zonen und erscheinen einem Betrachter dominanter und lenken zusätzlich noch von kleinen unscheinbareren Fehlern, wie etwa Dark Spots, Bright Spots, Pixel Shrinkage und/oder Wolken ab.

Die Struktur 06 kann auf die die Leuchtfläche 02 umfassende Oberfläche 12 der OLED 01 aufgetragen sein beziehungsweise entsprechend einer Ausgestaltung des Verfahrens auf die die Leuchtfläche 02 umfassende Oberfläche 12 der OLED 01 aufgetragen werden.

Für das hierzu verwendete Material für die Struktur 06 gibt es wie nachfolgend ausgeführt mehrere Möglichkeiten, um durch eine vorderseitige Auftragung einen Hell-Dunkel-Kontrast zwischen den mit der Struktur 06 bedeckten Bereichen und den benachbarten Partien 07, die frei von der Struktur 06 sind, herzustellen.

Die Lichtauskopplung kann beispielsweise durch eine vorderseitig im Bereich der Leuchtfläche 02 vorgesehene Struktur 06 aus zumindest im Wellenlängenbereich des von der mindestens einen Emitterschicht 04 der OLED 01 abgegebenen Lichts opakem Material abgeschwächt und/oder verhindert werden.

Die Lichtauskopplung kann beispielsweise durch eine vorderseitig im Bereich der Leuchtfläche vorgesehene Struktur 06 aus einem die Differenz der Brechungsindizes beim Übertritt von Licht zwischen Materialien mit unterschiedlichem Brechungsindex verringerndem Material erhöht werden.

Als ein geeignetes Material welches eine zwischen den Brechzahlen Luft und Glas liegende Brechzahl n aufweist, kommt beispielsweise Magnesiumfluorid (MgF₂) mit n = 1,38 in Frage.

Alternativen ergeben sich durch Aufbringen von prismatischen, beispielsweise mikroprismatischen Strukturen 06, strukturierten Diffusorfolien oder andersgearteten Oberflächen.

So kann das Verfahren beispielsweise vorsehen, eine der Struktur 06 entsprechende Geometrie aufweisende Diffusorfolie 10 auf die die Leuchtfläche 02 umfassende Oberfläche 12 der OLED 01 aufzutragen.

Alternativ oder zusätzlich zu einer Auftragung der Struktur 06 auf die die Leuchtfläche 02 umfassende Oberfläche 12 der OLED 01 kann die Struktur 06 auf die die Rückfläche 03 umfassende Oberfläche 13 der OLED 01 aufgetragen werden.

Für das hierzu verwendete Material für die Struktur 06 gibt es auch hierzu wie nachfolgend ausgeführt mehrere Möglichkeiten, um durch eine rückseitige Auftragung einen Hell-Dunkel-Kontrast zwischen den mit der Struktur 06 bedeckten Bereichen und den benachbarten Partien 07, die frei von der Struktur 06 sind, herzustellen.

So kann die Lichtauskopplung an der Leuchtfläche 02 durch eine rückseitig im Bereich der Rückfläche 03 vorgesehene Struktur 06 abgeschwächt werden, welche das auf sie auftreffende Licht zumindest zum Teil absorbiert und/oder die Lichtauskopplung des auf sie treffenden Lichts via der Rückfläche 03 der OLED 01 erhöht, so dass es anschließend nicht mehr zur Lichtauskopplung an der Leuchtfläche 02 zur Verfügung steht (Fig. 1, Fig. 2, Fig. 3).

Die Lichtauskopplung der Leuchtfläche 02 kann alternativ oder zusätzlich im Bereich der Struktur 06 durch eine rückseitig im Bereich der Rückfläche 03 vorgesehene Struktur 06 erhöht werden, welche eine Verkleinerung des Auftreffwinkels des von der Rückfläche 03 zur Leuchtfläche 02 reflektierten, von der oder den Emitterschichten 04 der OLED 01 im Warmzustand abgestrahlten Lichts auf die Leuchtfläche 02 zum Lot hin bewirkt, wodurch der durch Totalreflexion innerhalb der OLED 01 hin- und hergeworfene Anteil des Lichts verringert wird und die Lichtauskopplung insgesamt verbessert wird.

Gemäß dem Verfahren kann die Auftragung der Struktur 06 auf mehrere Arten und Weisen erfolgen.

Die einfachste Art ist, dass die Auftragung das Aufbringen der Struktur 06 direkt mit entsprechender Geometrie erfolgt.

Eine beispielsweise als die Lichtauskopplung aus der Leuchtfläche 02 der OLED 01 erhöhendes Material vorgesehene, bereits erwähnte Diffusorfolie 10 kann hierbei zunächst entsprechend der Geometrie der Struktur 06 ausgeschnitten und dann auf die die Leuchtfläche 02 umfassende Oberfläche 12 aufgebracht werden, entsprechend einer additiven Auftragung.

Eine weitere Möglichkeit zur Auftragung der Struktur 06 ist, dass zunächst ein vollflächiges Aufbringen des Materials der Struktur 06 auf die entsprechende Oberfläche 12, 13 erfolgt und anschließend das Material von denjenigen Partien 07, die frei von der Struktur sind, wieder entfernt wird.

So kann beispielsweise zunächst eine Diffusorfolie 10 vollflächig auf die die Leuchtfläche 02 umfassende Oberfläche 12 aufgebracht werden und anschließend der von der Geometrie der Struktur 06 nicht umfasste verbleibende Teil entfernt werden. Dies entspricht einer subtraktiven Auftragung durch Freilegung von freizuhaltenden Partien 07 unter Entfernung einer zuvor aufgebrachten Beschichtung und/oder Auftragung.

Weiterhin ist vorgesehen, dass die Struktur 06 zumindest abschnittsweise eine einen virtuellen Tiefeneffekt erzeugende Geometrie aufweist.

Zusätzlich zu den zuvor genannten Ausführungsformen lässt sich durch eine entsprechende visuelle Gestaltung der Struktur ein virtueller Tiefeneffekt erzeugen, welcher die Aufmerksamkeit nachfolgender Verkehrsteilnehmer auf eine entsprechend verwirklichte Lichtfunktion zieht, einhergehend mit einer Erhöhung der Verkehrssicherheit.

Geeignet ist hierzu beispielsweise eine in Fig. 4, Fig. 5, Fig. 6, Fig. 7 dargestellte Liniengestaltung der Struktur 06, welche eine optische Tiefenwirkung nachbildet.

Die Struktur 06 kann hierzu eine geometrische Anordnung von Linien umfassen.

Die Struktur kann beispielsweise zumindest eine regelmäßige geometrische Anordnung aus zumindest abschnittsweise parallel verlaufenden Linien umfassen.

Alternativ oder zusätzlich kann die Struktur zumindest abschnittsweise eine geometrische Anordnung von Linien umfassen, die einem gemeinsamen Fluchtpunkt oder zwei oder mehreren Fluchtpunkten zustreben.

Wird eine Struktur 06, die auch im Sinne einer Art optischer Täuschung eine dreidimensionale Erscheinung beinhalten kann (Fig. 5, Fig. 6, Fig. 7), auf transparente OLEDs 01 aufgebracht, ist es möglich eine noch größere Tiefenwirkung in einer Fahrzeugleuchte zu erzeugen, als dies bei intransparenten OLEDs 01 oder OLEDs 01 mit vollflächig aufgebrachter Diffusorfolie 10 möglich wäre.

Das in Fig. 4 dargestellte Ausführungsbeispiel kann eine oder mehrere transparente OLEDs 01 vorsehen.

Durch die aufgebrachte Struktur 06 hindurch ist bei einer transparenten OLED 01 eine dahinterliegende Leuchtfläche 02 noch teilweise zu erkennen. Vor allem durch ändern der Blickrichtung wird dem Betrachter klar, dass das zweite Element weiter hinten liegt. Die dahinterliegende Leuchtfläche 02 kann eine weitere OLED 01 sein oder auch bei einem hybriden Leuchtendesign ein LED-System, gegebenenfalls mit vorgeschalteter Optikscheibe. Auch können hinter der ersten transparenten und strukturiert ausgeführten OLED 01 eine oder mehrere weitere solcher OLEDs 01 angebracht sein, wodurch der Leuchtkörperfächer noch mehr Tiefenwirkung erhält, da die OLEDs 01 dann nicht nur von einer sondern von vielen OLEDs 01 durchstrahlt werden.

Eine weitere Alternative ist in Fig. 8 dargestellt. Dort sind innerhalb der Leuchtfläche 02 sowohl Strukturen 06 aus lichtauskopplungsförderndem Material, als auch Strukturen 06 aus lichtauskopplungsabschwächendem oder gar -verhinderndem, beispielsweise absorbierendem, kurz lichtauskopplungsunterbindendem Material punktartig innerhalb der Leuchtfläche 02 und/oder Rückfläche 03 angeordnet. Der verbleibende Teil der Leuchtfläche 02 und/oder Rückfläche 03 bildet eine Partie 07, die frei von der Struktur 06 ist.

Dort wo sich Strukturen 06 aus lichtauskopplungsförderndem Material befinden, leuchtet die Leuchtfläche 02 besonders hell auf, wohingegen dort, wo sich Strukturen 06 aus lichtauskopplungsabschwächendem oder gar -verhinderndem, beispielsweise absorbierendem, kurz lichtauskopplungsunterbindendem Material befinden, sie kaum oder gar nicht leuchtet. Im Bereich der dazwischen und herum befindlichen Partie 07, die frei von der Struktur 06 ist, findet eine normale Lichtauskopplung mit allen Fehlern, die die OLED 01 aufweist, statt. Hierdurch ergibt sich ein Gesamteindruck eines Blicks ins Universum mit - abhängig von der Größe der Strukturen 06 aus lichtauskopplungsförderndem Material helleren und weniger hellen Sternen, größeren und kleineren schwarzen Löchern und dem dazwischen liegenden Weltraumhintergrund.

Durch eine durch die partielle Auftragung der Struktur 06 auf wenigstens eine Oberfläche 12, 13 der OLED 01 hergestellte partielle Beschichtung oder Applikation können optische Mängel der Leuchtflächen 02 von OLEDs 01 sowohl im Kalt-, als auch im Warmzustand in Kauf genommen werden, wodurch mehr OLEDs 01 aus der Produktion verfügbar gemacht werden können, somit eine Kostensenkung durch eine Verwendbarkeit einer größeren Menge aller hergestellten OLEDs 01 erreicht wird, und die Umwelt durch eine geringere Ausschussquote, weniger Reklamationsfälle und eine geringere Austauschquote einhergehend mit einem geringeren Ressourcenverbrauch geschont wird.

Durch die Behandlung der Oberfläche durch Auftragung einer Struktur 06 mit vorsätzlich erzeugten Helligkeitsunterschieden innerhalb der Leuchtfläche 02 werden die einleitend genannten, bei OLEDs 01 auftretenden Fehler zwar nicht ausgemerzt, jedoch wird das Auge des Betrachters durch die Struktur 06 und durch die durch sie erzeugten Helligkeitsunterschiede sowohl im Kalt-, als auch im Warmzustand abgelenkt.

Hierdurch werden die bei gemäß den heutigen Fertigungsmethoden hergestellten OLEDs 01 innerhalb der Leuchtfläche auftretenden Fehler nicht mehr wahrgenommen, ohne sie zu kaschieren. Dadurch wird vermieden, dass die bislang einen Reklamationsgrund aufgrund eines negativen Qualitätseindrucks darstellenden, bei der überwiegenden Mehrzahl der hergestellten OLEDs 01 auftretenden, eingangs genannten Fehler auffallen. Hierdurch werden auch solche gemäß den heutigen Fertigungsmethoden hergestellten OLEDs 01 nunmehr als Lichtquellen in Fahrzeugleuchten verwendbar, die bislang aufwändig aussortiert werden mussten.

Das erfindungsgemäße Verfahren kann demnach alternativ formuliert werden zu einem Verfahren zur Steigerung der Verwendbarkeit von verfügbaren OLEDs 01 als Lichtquellen in Fahrzeugleuchten.

Die Steigerung der Verwendbarkeit von verfügbaren OLEDs 01 als Lichtquellen in Fahrzeugleuchten wird demnach durch die beschriebene Behandlung von Oberflächen 12, 13 von als Lichtquellen in Fahrzeugleuchten vorgesehenen OLEDs 01 vermittels Auftragung einer oder mehrerer einen Hell-Dunkel-Kontrast zumindest im Bereich der Leuchtfläche 02 erzeugender Strukturen 06 wenigstens auf die Leuchtfläche 02 und/oder die Rückfläche 03 der OLED 01 erreicht, von welcher Struktur 06 bevorzugt zumindest die Hälfte der Leuchtfläche 02 frei ist, welche Struktur 06 darüber hinaus zumindest jeweils zwei Bereiche der Leuchtfläche 02 und/oder der Rückfläche 03 einnimmt, und wobei entweder die Struktur 06 die Leuchtfläche 02 und/oder die Rückfläche 03 im mehrere Partien 07 unterteilt, die frei von der Struktur 06 sind, oder die Partien 07, die frei von der Struktur 06 sind, die Leuchtfläche 02 und/oder die Rückfläche 03 im mehrere mit der Struktur 06 versehene Bereiche unterteilt.

Die Erfindung sieht somit vor, durch Aufbringen von optisch dominierenden Elementen auf der die Leuchtfläche 02 umfassenden Oberfläche 12 und/oder die dieser gegenüberliegenden Rückfläche 03 umfassenden Oberfläche 13 einer zur Verwendung als Lichtquelle in einer Fahrzeugleuchte vorgesehenen OLED 01, von einigen der eingangs genannten Fehler, insbesondere Dark Spots und Bright Spots, Pixel Shrinkage sowie Wolken abzulenken. Hierdurch wird der Qualitätseindruck erhöht und vermieden, dass die genannten Fehler die Qualität beeinträchtigen und an der fertigen Fahrzeugleuchte eine Mangelbeseitigung gefordert wird. Durch die optische Dominanz der Elemente wird von den optisch minder dominanten Fehlern abgelenkt.

Erreicht wird dieser kaschierenden Effekt durch optische- und/oder prismatische und/oder beispielsweise mikrooptische und/oder ähnliche, beispielsweise grafische Strukturen 06, die subtraktiv durch Entfernung und/oder additiv durch Hinzufügung hergestellt werden können, wie etwa beispielsweise mikroprismatische Strukturen, Ätzungen oder Sandstrahloberflächen. Durch einige dieser Veredelungsprozesse erfährt die OLED 01 zusätzlich eine Steigerung ihrer Auskopplungs-Effizienz.

Auch wird die eingeschränkte Verfügbarkeit von OLED-Herstellern für automotive OLEDs 01 vergrößert, da mit dieser Erfindung auch OLED-Hersteller für die Anwendung in Betracht gezogen werden können, die aktuell noch mit Dark Spots Probleme haben. Damit hilft die Erfindung auch bei der Befähigung neuer OLED-Lieferanten und dem Einsatz deren OLEDs für automotive Anwendungen.

Es ist ersichtlich, dass die Erfindung zur Behebung der Nachteile des Standes der Technik und zur volständigen Lösung der gestellten Aufgabe einhergehend mit einer Erhöhung der zur Verfügung stehenden OLEDs 01 und einer hiermit verbundenen Kostenreduktion die Aufbringung mindestens einer nur Teile der Leuchtfläche einnehmenden Struktur vorsieht, welche einen Hell-Dunkel-Kontrast erzeugt, der von den negativen Qualitätseindrücken innerhalb der Leuchtfläche 02 ablenkt.

Die Erfindung löst die gestellte Aufgabe durch eine Veredelung beziehungsweise einen oder mehrere Veredelungsprozesse in Bezug auf das optische Erscheinungsbild, wodurch Fehlstellen innerhalb der Leuchtflächen unter anderem auch von ansonsten nicht verwendbaren OLEDs nicht mehr auffallen.

Auch kann die Abstrahlcharakteristik von OLEDs 01 mit der Struktur 06 auf der Vorder- und der Rückseite nach einer Vorgabe angepasst werden. Die Abstrahlcharakteristiken müssen auf der Vorder- und Rückseite der OLED somit nicht identisch sein, wie in Fig. 1, Fig. 2 und Fig. 3 durch Lichtstrahlen andeutende Pfeile dargestellt.

Die Erfindung ist insbesondere im Bereich der Herstellung von Fahrzeugleuchten, insbesondere Kraftfahrzeugleuchten gewerblich anwendbar.

Die Erfindung wurde unter Bezugnahme auf bevorzugte Ausführungsformen beschrieben. Es ist jedoch für einen Fachmann vorstellbar, dass Abwandlungen oder Änderungen der Erfindung gemacht werden können, ohne dabei den Schutzbereich der nachstehenden Ansprüche zu verlassen.

### Bezugszeichenliste

- 01: OLED
- 02: Leuchtfläche
- 03: Rückfläche
- 04: Emitterschicht
- 05: Randfläche
- 06: Struktur
- 07: Partie, die frei von der Struktur 06 ist
- 08: Substrat und/oder Verkapselung
- 10: Diffusorfolie
- 11: OLED-Halterung
- 12: Oberfläche der OLED 01, welche die Leuchtfläche 02 umfasst
- 13: Oberfläche der OLED 01, welche die Rückfläche 03 umfasst

## Patentansprüche

1. Verfahren zur Behandlung wenigstens einer Oberfläche (12, 13) einer als Lichtquelle in einer Fahrzeugleuchte vorgesehenen OLED (01) mit einer zur vorderseitigen Lichtabstrahlung vorgesehene Leuchtfläche (02) sowie einer der Leuchtfläche (02) gegenüberliegende Rückfläche (03), umfassend eine Auftragung einer oder mehrerer Strukturen (06) wenigstens auf die Leuchtfläche (02) und/oder der Rückfläche (03), welche Struktur (06) wenigstens im Warmzustand einen Hell-Dunkel-Kontrast zumindest innerhalb der Leuchtfläche (02) erzeugt, wobei die Struktur (06) zumindest innerhalb des von der Leuchtfläche (02) eingenommenen Bereichs auf der die Leuchtfläche (02) umfassenden Oberfläche (12) der OLED (01) und/oder der die der Leuchtfläche (02) gegenüberliegenden Rückfläche (03) umfassenden Oberfläche (13) der OLED (01) aufgetragen wird, und die Auftragung zum Erhalt des Hell-Dunkel-Kontrasts an der fertig behandelten Oberfläche (12, 13) der OLED (01):
- mehrere voneinander durch Teile der Struktur (06) voneinander getrennte Partien (07) vorsieht, die frei von der Struktur (06) sind, und/oder
- mehrere voneinander durch Partien (07), die frei von der Struktur (06) sind, voneinander getrennte Teile der Struktur (06) vorsieht,
wobei die Auftragung der Struktur (06) ein Aufbringen eines die Lichtauskopplung aus der Leuchtfläche (02) abschwächenden und/oder verhindernden Materials auf die Leuchtfläche (02) und/oder die Rückfläche (03) umfasst, wobei die Struktur zumindest abschnittsweise eine einen virtuellen Tiefeneffekt erzeugende Geometrie aufweist, **dadurch gekennzeichnet, dass** zunächst ein die Lichtauskopplung aus der Leuchtfläche (02) erhöhendes Material zumindest auf die Leuchtfläche (02) und/oder die Rückfläche (03) vollflächig aufgebracht wird, und anschließend die Auftragung der Struktur (06) aus einem die Lichtauskopplung aus der Leuchtfläche (02) abschwächenden und/oder gar verhindernden Material unter Freilassung der Partien (07), die frei von der mindestens einen Struktur (06) sind, erfolgt.

2. Verfahren nach Anspruch 1, wobei die Auftragung der Struktur (06) vorsieht, dass an der fertig behandelten Oberfläche (12, 13) zumindest der selbe Flächenanteil frei von der Struktur (06) ist, wie derjenige von der Struktur (06) eingenommene Flächenanteil.

3. Verfahren nach Anspruch 1 oder 2, wobei die Struktur (06) auf die die Leuchtfläche (02) umfassende Oberfläche (12) der OLED (01) aufgetragen wird.

4. Verfahren nach Anspruch 1, 2 oder 3, wobei die Struktur (06) auf die die Rückfläche (03) umfassende Oberfläche (13) der OLED (01) aufgetragen wird.

5. Verfahren nach einem der Ansprüche 1 bis 4, wobei die Auftragung zunächst ein vollflächiges Aufbringen des Materials der Struktur (06) und ein anschließendes Entfernen des Materials auf denjenigen Partien (07), die frei von der Struktur sind, vorsieht.

6. Leuchtmittel zur Erfüllung einer Lichtfunktion einer Fahrzeugleuchte oder zum Beitrag einer vorgegebenen Lichtverteilung einer Lichtfunktion einer Fahrzeugleuchte mit mindestens einer OLED (01) als Lichtquelle mit einer zur vorderseitigen Lichtabstrahlung vorgesehene Leuchtfläche (02) sowie einer der Leuchtfläche (02) gegenüberliegende Rückfläche (03), umfassend eine oder mehrere Strukturen (06) wenigstens auf der Leuchtfläche (02) und/oder der Rückfläche (03), welche Struktur (06) wenigstens im Warmzustand einen Hell-Dunkel-Kontrast zumindest innerhalb der Leuchtfläche (02) erzeugt, wobei die Struktur (06) zumindest innerhalb des von der Leuchtfläche (02) eingenommenen Bereichs auf der die Leuchtfläche (02) umfassenden Oberfläche (12) der OLED (01) und/oder der die der Leuchtfläche (02) gegenüberliegenden Rückfläche (03) umfassenden Oberfläche (13) der OLED (01) aufgetragen ist, und zum Erhalt des Hell-Dunkel-Kontrasts an der fertig behandelten Oberfläche (12, 13) der OLED (01):
- mehrere voneinander durch Teile der Struktur (06) voneinander getrennte Partien (07) vorsieht, die frei von der Struktur (06) sind, und/oder
- mehrere voneinander durch Partien (07), die frei von der Struktur (06) sind, voneinander getrennte Teile der Struktur (06) vorsieht,
wobei:
- die Struktur (06) ein die Lichtauskopplung aus der Leuchtfläche (02) abschwächendes und/oder verhinderndes Material auf der Leuchtfläche (02) und/oder der Rückfläche (03) umfasst,
- die Struktur zumindest abschnittsweise eine einen virtuellen Tiefeneffekt erzeugende Geometrie aufweist,
**dadurch gekennzeichnet, dass**
- ein die Lichtauskopplung aus der Leuchtfläche (02) erhöhendes Material zumindest auf die Leuchtfläche (02) und/oder die Rückfläche (03) vollflächig aufgebracht ist, und
- die Struktur (06) aus einem die Lichtauskopplung aus der Leuchtfläche (02) abschwächenden und/oder gar verhindernden Material unter Freilassung der Partien (07), die frei von der mindestens einen Struktur (06) sind, entweder auf das die Lichtauskopplung aus der Leuchtfläche erhöhende Material aufbracht ist oder auf die des die Lichtauskopplung aus der Leuchtfläche erhöhenden Materials abgewandte Seite der OLED aufbracht ist.

## Claims

1. A method for the treatment of at least one surface (12, 13) of an OLED (01) provided as light source in a vehicle lamp, the OLED (0) having a luminous surface (02) provided for front light emission and a back surface (03) opposite the luminous surface (02), the method comprising an application of one or more structures (06) onto at least the luminous surface (02) and/or onto the back surface (03), which structure (06), at least in the warm state, produces a light-dark contrast at least within the luminous surface (02), wherein, at least within the region covered by the luminous surface (02), the structure (06) is applied onto the surface (12) of the OLED (01) comprising the luminous surface (02) and/or onto the surface (13) of the OLED (01) comprising the back surface (03) opposite the luminous surface (02), and, in order to obtain the light-dark contrast at the finished treated surface (12, 13) of the OLED (01), the application provides:
- a plurality of structure-free sections (07) separated from each other by parts of the structure (06), and/or
- a plurality of parts of the structure (06) separated from each other by structure-free sections (07),
wherein the application of the structure (06) comprises an application of a material onto the luminous surface (02) and/or onto the back surface (03), which material reduces and/or prevents the light outcoupling from the luminous surface (02), wherein the structure at least in sections has a geometry that produces a virtual depth effect,
**characterised in that**, first, a material that increases the light outcoupling from the luminous surface (02) is applied onto at least the entire luminous surface (02) and/or onto the entire back surface (03), and subsequently, the application of the structure (06) resulting from a material that reduces and/or even prevents the light outcoupling from the luminous surface (02) is carried out leaving free the sections (07) that are free of the at least one structure (06).

2. The method according to claim 1, wherein the application of the structure (06) provides that, on the finished treated surface (12, 13), the proportion of the surface that is free of the structure (06) is at least the same as the proportion of the surface covered by the structure (06).

3. The method according to claim 1 or 2, wherein the structure (06) is applied onto the surface (12) of the OLED (01) comprising the luminous surface (02).

4. The method according to claim 1, 2, or 3, wherein the structure (06) is applied onto the surface (13) of the OLED (01) comprising the back surface (03).

5. The method according to one of the claims 1 to 4, wherein the application first provides an application of the material of the structure (06) onto the entire surface and a subsequent removal of the material from those sections (07) that are free of the structure.

6. A lighting means for fulfilling a light function of a vehicle lamp or for contributing a specified light distribution of a light function of a vehicle lamp, with at least one OLED (01) as light source, with a luminous surface (02) provided for front light emission, and with a back surface (03) opposite the luminous surface (02), comprising one or more structures (06), at least on the luminous surface (02) and/or on the back surface (03), which structure (06), at least in the warm state, produces a light-dark contrast at least within the luminous surface (02), wherein, at least within the region covered by the luminous surface (02), the structure (06) is applied onto the surface (12) of the OLED (01) comprising the luminous surface (02) and/or onto the surface (13) of the OLED (01) comprising the back surface (03) opposite the luminous surface (02), and, in order to obtain the light-dark contrast at the finished treated surface (12, 13) of the OLED (01), the structure provides:
- a plurality of structure-free sections (07) separated from each other by parts of the structure (06), and/or
- a plurality of parts of the structure (06) separated from each other by structure-free sections (07),
wherein:
- the structure (06) comprises a material on the luminous surface (02) and/or on the back surface (03), which material reduces and/or prevents the light outcoupling from the luminous surface (02),
- wherein the structure at least in sections has a geometry that produces a virtual depth effect,
**characterised in that**
- a material that increases the light outcoupling from the luminous surface (02) is applied onto at least the entire luminous surface (02) and/or onto the entire back surface (03), and **in that**
- the structure (06) resulting from a material that reduces and/or even prevents the light outcoupling from the luminous surface (02), with the sections (07) that are free from the at least one structure (06) having been left out, is applied either onto the material increasing the light outcoupling from the luminous surface or onto the side of the OLED averted from the material increasing the light outcoupling from the luminous surface.

## Revendications

1. Procédé de traitement d'au moins une surface (12, 13) d'une diode électroluminescente organique (01) prévue comme source lumineuse dans un phare de véhicule avec une surface lumineuse (02) prévue pour l'émission de lumière du côté avant ainsi qu'une surface arrière (03) opposée à la surface lumineuse (02), comprenant une application d'une ou de plusieurs structures (06) au moins sur la surface lumineuse (02) et/ou sur la surface arrière (03), laquelle structure (06) crée au moins à l'état chaud un contraste clair-sombre au moins à l'intérieur de la surface lumineuse (02), ladite structure (06) étant appliquée au moins à l'intérieur de la zone occupée par la surface lumineuse (02) sur la surface (12) de la diode électroluminescente organique (01) comprenant la surface lumineuse (02) et/ou sur la surface (13) de la diode électroluminescente organique (01) comprenant la surface arrière (03) opposée à la surface lumineuse (02), et l'application pour obtenir le contraste clair-sombre sur la surface (12, 13) traitée finie de la diode électroluminescente organique (01) :
- prévoit plusieurs parties (07) séparées les unes des autres par des parties de la structure (06), qui sont exemptes de la structure (06), et/ou
- prévoit plusieurs parties de la structure (06) séparées les unes des autres par des parties (07) qui sont exemptes de la structure (06),
l'application de la structure (06) comprenant une application d'un matériau atténuant et/ou empêchant le découplage de lumière de la surface lumineuse (02) sur la surface lumineuse (02) et/ou sur la surface arrière (03), la structure présentant au moins par sections une géométrie produisant un effet de profondeur virtuel,
**caractérisé en ce qu'**un matériau augmentant le découplage de la lumière de la surface lumineuse (02) est d'abord appliqué sur toute la surface au moins sur la surface lumineuse (02) et/ou sur la surface arrière (03), et qu'ensuite l'application de la structure (06) en un matériau atténuant et/ou même empêchant le découplage de la lumière de la surface lumineuse (02) est effectuée en laissant libres les parties (07) qui sont exemptes de ladite au moins une structure (06).

2. Procédé selon la revendication 1, l'application de la structure (06) prévoyant que, sur la surface traitée finie (12, 13), au moins la même portion de surface est exempte de la structure (06) que la portion de surface occupée par la structure (06).

3. Procédé selon la revendication 1 ou 2, la structure (06) étant appliquée sur la surface (12) de la diode électroluminescente organique (01) comprenant la surface lumineuse (02).

4. Procédé selon la revendication 1, 2 ou 3, la structure (06) étant appliquée sur la surface (13) de la diode électroluminescente organique (01) comprenant la surface arrière (03).

5. Procédé selon l'une des revendications 1 à 4, l'application prévoyant d'abord une application du matériau de la structure (06) sur toute la surface, et ensuite une élimination du matériau sur les parties (07) qui sont exemptes de structure.

6. Moyen d'éclairage pour remplir une fonction d'éclairage d'un phare de véhicule ou pour contribuer à une répartition de lumière prédéterminée d'une fonction d'éclairage d'un phare de véhicule avec au moins une diode électroluminescente organique (01) comme source lumineuse avec une surface lumineuse (02) prévue pour l'émission de lumière du côté avant ainsi qu'une surface arrière (03) opposée à la surface lumineuse (02), comprenant une ou plusieurs structures (06) au moins sur la surface lumineuse (02) et/ou sur la surface arrière (03), laquelle structure (06) crée au moins à l'état chaud un contraste clair-sombre au moins à l'intérieur de la surface lumineuse (02), ladite structure (06) étant appliquée au moins à l'intérieur de la zone occupée par la surface lumineuse (02) sur la surface (12) de la diode électroluminescente organique (01) comprenant la surface lumineuse (02) et/ou sur la surface arrière (03) de la diode électroluminescente organique (01) comprenant la surface arrière (03) opposée à la surface lumineuse (02), et pour obtenir le contraste clair-sombre sur la surface (12, 13) traitée finie de la diode électroluminescente organique (01) :
- prévoit plusieurs parties (07) séparées les unes des autres par des parties de la structure (06), qui sont exemptes de la structure (06), et/ou
- prévoit plusieurs parties de la structure (06) séparées les unes des autres par des parties (07) qui sont exemptes de la structure (06),
dans lequel :
- la structure (06) comprend un matériau sur la surface lumineuse (02) et/ou sur la surface arrière (03) qui atténue et/ou qui empêche le découplage de lumière de la surface lumineuse (02),
- la structure présente au moins par portions une géométrie créant un effet de profondeur virtuel,
**caractérisé en ce que**
- un matériau augmentant le découplage de lumière de la surface lumineuse (02) est appliqué, sur toute la surface, au moins sur la surface lumineuse (02) et/ou sur la surface arrière (03), et
- la structure (06) en un matériau atténuant et/ou empêchant le découplage de lumière de la surface lumineuse (02), en laissant libres les parties (07) qui sont exemptes de l'au moins une structure (06), est appliquée soit sur le matériau augmentant le découplage de lumière de la surface lumineuse, soit sur la surface de la diode électroluminescente organique opposée au matériau augmentant le découplage de lumière de la surface lumineuse.
